# EUROPEAN PATENT APPLICATION

(11) **EP 4 665 092 A1**
(43) Date of publication of application: **17.12.2025**
(21) Application number: 25751712.8
(22) Date of filing: 08.02.2025
(51) Int. Cl.: H05K 1/18, H05K 1/11, H05K 1/14, H05K 1/02, G06F 1/16

(54) **CIRCUIT BOARD ASSEMBLY AND ELECTRONIC APPARATUS**

(30) Priority: 08.02.2024 CN 202410175838
(71) Applicant: Honor Device Co., Ltd., Shenzhen, Guangdong 518040 (CN)
(72) Inventor: JIANG, Zairan, Shenzhen, Guangdong 518040 (CN)
(74) Representative: Isarpatent
(86) International application number: PCT/CN2025/076439
(87) International publication number: WO 2025/168102

(57) **Abstract**

Embodiments of this application provide a circuit board assembly and an electronic device. The circuit board assembly includes a circuit board, a connection board, and a second electronic component. The circuit board has a circuit board body and a first electronic component, and the first electronic component is located on the circuit board body. A first signal hole is provided on the circuit board body. The connection board is located on a side of the circuit board body opposite to the first electronic component, and is in conduction with the first electronic component through the first signal hole. The second electronic component is in conduction with the connection board. According to the circuit board assembly in this application, when transmission of a signal between the first electronic component and the second electronic component is implemented, the first signal hole can be fully used, to avoid generation of a stub of a signal between the first electronic component and the second electronic component in the first signal hole, thereby improving quality of the signal between the first electronic component and the second electronic component.

## Description

This application claims priority to Chinese Patent Application No. 202410175838.8, filed with the China National Intellectual Property Administration on February 8, 2024 and entitled "CIRCUIT BOARD ASSEMBLY AND ELECTRONIC DEVICE" filed in China, which is incorporated herein by reference in its entirety.

### TECHNICAL FIELD

This application relates to the field of electronic technologies, and in particular, to a circuit board assembly and an electronic device.

### BACKGROUND

Currently, electronic devices such as a notebook computer and a tablet computer play important roles in people's daily life and work. The existence of the electronic devices greatly facilitates people's life and work. With continuous development of electronic technologies, requirements of people on performance of the electronic devices are increasingly higher.

An electronic device has a circuit board. As a core component of the electronic device, the circuit board plays an important role in the electronic device. Performance of the circuit board directly affects performance of the electronic device. The circuit board includes a circuit board body and a large quantity of electronic components. The circuit board body carries the large quantity of electronic components. Currently, the circuit board body in the circuit board is mostly provided with signal holes, so that transmission of a signal between the electronic components carried on the circuit board can be implemented through the signal holes. For example, transmission of a signal between a central processing unit and a double data rate synchronous dynamic random access memory (random access memory for short) on the circuit board body can be implemented through a signal hole on the circuit board.

When the transmission of the signal between the central processing unit and the random access memory is implemented through the signal hole, a stub (stub) is generated in the signal hole of the circuit board body. The stub may deteriorate signal quality, and consequently, a rate of the random access memory cannot be increased to a maximum rate that can be supported by the electronic device, limiting improvement of the performance of the circuit board.

### SUMMARY

This application provides a circuit board assembly and an electronic device, so that during transmission of a signal between a first electronic component and a second electronic component, a first signal hole can be fully used, to avoid generation of a stub during transmission in the first signal hole, thereby improving quality of the signal between the first electronic component and the second electronic component.

A first aspect of embodiments of this application provides a circuit board assembly. The circuit board assembly includes:
a circuit board, having a circuit board body and a first electronic component, where the first electronic component is located on the circuit board body; and a signal hole is provided on the circuit board body, and the signal hole includes a first signal hole;
a connection board, located on a side of the circuit board body opposite to the first electronic component, and in conduction with the first electronic component through the first signal hole; and
a second electronic component, in conduction with the connection board.

According to the circuit board assembly in embodiments of this application, through the arrangement of the connection board, the first electronic component may be in conduction with the second electronic component by using the first signal hole on the circuit board body and the connection board, so that the first signal hole can be fully used during transmission of a signal (second electronic component signal for short) between the first electronic component and the second electronic component, to avoid generation of a stub in the first signal hole. In this application, a back-drilling process is not required, so that the second electronic component can be close to the first electronic component, thereby improving quality of the second electronic component signal, and ensuring better performance of the second electronic component.

In some possible implementations, the connection board is a high density interconnector, a first signal channel is provided in the connection board, a first end of the first signal channel is in conduction with the first electronic component through the first signal hole, and a second end of the first signal channel is in conduction with the second electronic component; and

when a signal between the second electronic component and the first electronic component is transmitted in the first signal channel, a stub is not generated in the first signal channel of the connection board.

In this way, the connection board implements conduction between the first electronic component and the second electronic component through the first signal channel, to ensure that when the first electronic component is electrically connected to the second electronic component, the first signal hole and the first signal channel can be fully used during transmission of the second electronic component signal, and a stub is not generated in the first signal hole and the first signal channel.

Compared with the manner of using the high density interconnector for the circuit board body to resolve that the second electronic component signal generates the stub in the first signal hole, in this application, only the connection board is arranged, which can prevent the second electronic component signal from generating the stub in the first signal hole, and can reduce manufacturing costs of the circuit board assembly.

In some possible implementations, a first conduction portion is provided between the first electronic component and the circuit board body, and the first electronic component is connected to a first end of the first signal hole through the first conduction portion; and a second conduction portion is provided between the connection board and the circuit board body, and a second end of the first signal hole is connected to the first end of the first signal channel through the second conduction portion.

The first electronic component can be in conduction with the first end of the first signal channel through the first conduction portion and the second conduction portion. In addition, because of introduction of the connection board, a signal fan-out area of the first electronic component can be reduced. In this way, the second electronic component is closer to the first electronic component, thereby further reducing an insertion loss of the second electronic component signal and improving the quality of the second electronic component signal.

In some possible implementations, the first signal hole is located on a side of the first conduction portion, which can simplify a forming process of the first signal hole and reduce manufacturing costs of the circuit board assembly.

In some possible implementations, a plurality of first conduction portions are provided, and each first conduction portion is provided with the first signal hole and the second conduction portion are correspondingly; and

each second conduction portion of the connection board is provided with the first signal channel correspondingly, so that a plurality of transmission paths are formed between the first electronic component and the second electronic component. A plurality of second electronic component signals are transmitted through respective transmission paths, so that mutual interference between the second electronic component signals can be avoided when a transmission rate of the second electronic component signals is improved.

In some possible implementations, a third conduction portion is provided between the second electronic component and the connection board, and the third conduction portion is connected between the second end of the first signal channel and the second electronic component, so that the second electronic component is in conduction with the connection board through the third conduction portion.

In some possible implementations, the second electronic component is located on a side of the connection board facing the first electronic component; and the first end of the first signal channel and the second end of the first signal channel are formed on a side of the connection board facing the circuit board body, to ensure that the first signal channel is in conduction with the first electronic component and the second electronic component.

In some possible implementations, the second electronic component is connected to a side the circuit board body on which the first electronic component is arranged, to ensure conduction between the first electronic component and the second electronic component, to avoid generation of the stub during transmission of the second electronic component signal in the first signal hole. In this way, when the quality of the second electronic component signal is improved, the first electronic component and the second electronic component can be arranged on the same surface of the circuit board body.

In some possible implementations, the signal hole further includes a second signal hole, and the second signal hole is provided at a location corresponding to the third conduction portion on the circuit board body; and
a first end of the second signal hole is connected to the second electronic component, and a second end of the second signal hole is connected to the third conduction portion.

Through connections among the second signal hole, the second electronic component, and the third conduction portion, when the second electronic component is in conduction with the connection board, the second signal hole can be fully used during transmission of the second electronic component signal, to avoid generation of a stub in the second signal hole.

In some possible implementations, a fourth conduction portion is provided between the second electronic component and the circuit board body, and the second electronic component is connected to the first end of the second signal hole through the fourth conduction portion, so that the second electronic component is in conduction with the connection board.

In some possible implementations, the circuit board assembly further includes a transit board, where the second electronic component is connected to the first end of the second signal hole through the transit board, to ensure that the second signal hole is provided on the circuit board body when the second electronic component is in conduction with the circuit board body through the transit board.

In some possible implementations, the second electronic component has a second projection region on the circuit board body;
a projection of the connection board on the circuit board body and the second projection region have a second overlapping region; and the second signal hole is located in the second overlapping region. In this way, when the second electronic component is in conduction with the connection board through the second signal hole, the second electronic component can be closer to the first electronic component, thereby improving the quality of the second electronic component signal.

In some possible implementations, the second electronic component is located in the circuit board body, so that the second electronic component can be hidden in the circuit board body when the second electronic component is in conduction with the second electronic component, to prevent an excessively thick circuit board assembly from affecting a thickness of a body of the electronic device.

In some possible implementations, the second electronic component is located on a side of the connection board away from the first electronic component, so that the second electronic component and the first electronic component are arranged on different surfaces of the circuit board body.

The first end of the first signal channel is formed on the side of the connection board facing the circuit board body, and the second end of the first signal channel is formed on a side of the connection board facing the second electronic component, so that the second electronic component is in conduction with the first electronic component through the first signal channel.

In some possible implementations, a quantity of third conduction portions and a quantity of first signal channels are the same, and the third conduction portions and the first signaling channels are in a one-to-one correspondence, so that each first signal channel of the connection board can be in conduction with the second electronic component through one third conduction portion, to implement transmission of the second electronic component signal in each transmission path.

In some possible implementations, the connection board includes a conductive portion and a plurality of stacked conductive circuit layers, and adjacent conductive circuit layers are insulated from each other; and at least two conductive circuit layers located in a middle layer of the connection board form a core board unit of the connection board, and adjacent conductive circuit layers located on a side of the core board unit are interconnected through the conductive portion; and
the first signal channel is at least formed at the conductive portion on a side of the core board unit facing the circuit board body, so that the first signal channel is formed through the conductive portion that interconnects the adjacent conductive circuit layers. In this way, during transmission of the second electronic component signal in the first signal channel, the second electronic component signal can be prevented from passing through a useless conductive circuit layer when passing through the first signal channel, thereby avoiding generation of the stub.

In some possible implementations, adjacent conductive circuit layers in the core board unit are interconnected through the conductive portion.

In some possible implementations, the signal hole is a signal via or a signal buried via on the circuit board body, to resolve a problem of generation of a stub during transmission of the second electronic component signal in the signal via or the signal buried via of the circuit board body.

In some possible implementations, the first electronic component has a first projection region on the circuit board body;
the projection of the connection board on the circuit board body and the first projection region have a first overlapping region; and the first signal hole is located in the first overlapping region. In this way, the signal fan-out area of the first electronic component can be zero, thereby further improving the quality of the second electronic component signal.

In some possible implementations, the circuit board body has a first surface and a second surface in a board thickness direction, and the second surface faces a keyboard of the electronic device; and
the first electronic component is arranged on the first surface, and the connection board is arranged on the second surface so that the connection board is located on the side of the circuit board body opposite to the first electronic component. In this way, when it is ensured that the connection board can be in conduction with the first electronic component through the first signal hole, heat dissipation of the first electronic component can be facilitated, thereby improving user experience of the electronic device.

In some possible implementations, the circuit board assembly further includes an isolation member, where the isolation member covers at least one side of the second electronic component, to shield the second electronic component through the isolation member, thereby preventing the second electronic component from affecting another signal of the electronic device.

In some possible implementations, the isolation member includes an isolation hood or an isolation plate, so that a structure of the isolation member can be diversified when the second electronic component is shielded, to adapt to design requirements of the circuit board assembly on the isolation member in different scenarios.

In some possible implementations, the first electronic component includes a processor, and the second electronic component includes a memory, to improve performance of the memory, so that a rate of the memory can be increased to a maximum rate that can be supported by the electronic device.

A second aspect of embodiments of this application provides an electronic device. The electronic device includes a housing and the circuit board assembly according to any one of the foregoing descriptions. The circuit board assembly is located in the housing, to ensure better performance of a second electronic component in the circuit board assembly, thereby improving performance of the circuit board assembly.

### BRIEF DESCRIPTION OF DRAWINGS

FIG. 1 is a schematic diagram of a structure of an electronic device according to an embodiment of this application;
FIG. 2 is a schematic diagram of an internal structure of a body of an electronic device according to an embodiment of this application;
FIG. 3 is a partial schematic diagram of a first circuit board in a core region in conventional technologies;
FIG. 4 is a partial detailed diagram of a circuit board body in FIG. 3 at a first signal hole and a second signal hole;
FIG. 5 is a partial schematic diagram of a second circuit board in a core region in the conventional technologies;
FIG. 6 is a partial schematic diagram of a circuit board assembly in the conventional technologies;
FIG. 7 is a schematic diagram of another circuit board assembly in the conventional technologies;
FIG. 8 is a schematic diagram of a structure of eliminating a stub on a circuit board body through back-drilling in the conventional technologies;
FIG. 9 is a schematic diagram of a structure of a first circuit board assembly according to an embodiment of this application;
FIG. 10 is a schematic diagram of a structure of a connection board according to an embodiment of this application;
FIG. 11 is a schematic diagram of a structure of another connection board according to an embodiment of this application;
FIG. 12 is a schematic diagram of a structure of still another connection board according to an embodiment of this application;
FIG. 13 is a schematic diagram of a structure of yet still another connection board according to an embodiment of this application;
FIG. 14 is a schematic diagram of cabling of a signal in a low-order high density interconnector according to an embodiment of this application;
FIG. 15 is a schematic diagram of a structure of a second circuit board assembly according to an embodiment of this application;
FIG. 16 is a schematic diagram of a structure of a third circuit board assembly according to an embodiment of this application;
FIG. 17 is a schematic diagram of a structure of a fourth circuit board assembly according to an embodiment of this application;
FIG. 18 is a first schematic diagram of cabling of a second electronic component signal in a connection board when a first electronic component and a second electronic component are arranged on the same surface of the connection board according to an embodiment of this application;
FIG. 19 is a second schematic diagram of cabling of a second electronic component signal in a connection board when a first electronic component and a second electronic component are arranged on the same surface of the connection board according to an embodiment of this application;
FIG. 20 is a third schematic diagram of cabling of a second electronic component signal in a connection board when a first electronic component and a second electronic component are arranged on the same surface of the connection board according to an embodiment of this application;
FIG. 21 is a schematic diagram of a structure of a fifth circuit board assembly according to an embodiment of this application;
FIG. 22 is a schematic diagram of a structure of a sixth circuit board assembly according to an embodiment of this application;
FIG. 23 is a first schematic diagram of cabling of a second electronic component signal in a connection board when a first electronic component and a second electronic component are arranged on different surfaces of the connection board according to an embodiment of this application;
FIG. 24 is a second schematic diagram of cabling of a second electronic component signal in a connection board when a first electronic component and a second electronic component are arranged on different surfaces of the connection board according to an embodiment of this application; and
FIG. 25 is a third schematic diagram of cabling of a second electronic component signal in a connection board when a first electronic component and a second electronic component are arranged on different surfaces of the connection board according to an embodiment of this application.

### Reference numerals:

100-electronic device;
1-screen member; 11-screen housing; 12-display screen;
2-body; 21-base; 22-keyboard; 23-touch pad;
3-rotating shaft mechanism;
4-circuit board; 41-circuit board body; 411-first signal hole; 412-second signal hole; 413-working layer; 414-first conduction portion; 415-second conduction portion; 416-third conduction portion; 417-fourth conduction portion; 418-fifth conduction portion; 42-central processing unit; 421-base board; 422-chip; 423-encapsulation layer; 43-random access memory; 44-core region; 45-first connection portion; 46-second connection portion; 47-third connection portion; 48-first electronic component; 49-second electronic component;
5-fan;
6-connection board; 61-first signal channel; 62-conductive circuit layer; 63-insulation layer; 64-core board unit; 641-first side; 642-second side; 65-conductive portion; 651-first conductive portion; 652-second conductive portion; 653-third conductive portion; 654-fourth conductive portion; 655-fifth conductive portion; 66-signal buried via; 67-conductive group;
7-transit board; 71-second signal channel;
8-drill bit;
9-isolation member;
SO-signal fan-out area; S1-first overlapping region; and S2-second overlapping region.

### DESCRIPTION OF EMBODIMENTS

Terms used in implementations of this application are merely intended to explain specific embodiments of this application rather than being intended to limit this application.

An embodiment of this application provides an electronic device. The electronic device may include, but is not limited to, a mobile or fixed terminal such as a computer, a mobile phone, an unmanned aerial vehicle, a netbook, a personal digital assistant (personal digital assistant, PDA), an ultra-mobile personal computer (ultra-mobile personal computer, UMPC), a hand-held computer, an intelligent wearable device, a virtual reality (virtual reality, VR) device, a server, or a point of sales (point of sales, POS). The computer may include a notebook computer, a tablet computer (namely, pad), and the like.

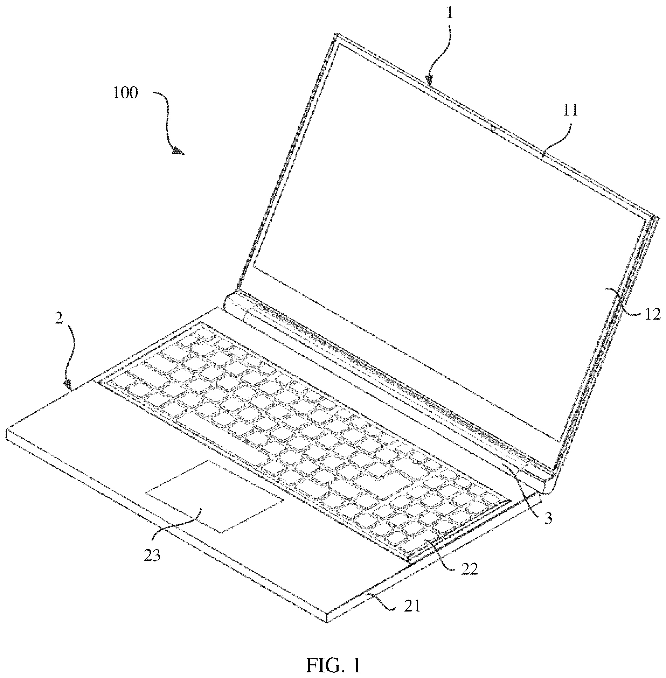

FIG. 1 shows an example of a structure of an electronic device 100. The electronic device 100 is a notebook computer. The structure of the electronic device 100 is further described below by using the notebook computer as an example.

Refer to FIG. 1. The electronic device 100 may include a screen member 1 and a body 2. The screen member 1 may be configured to display information and provide an interactive interface for a user. The body 2 includes an input apparatus, and the user may perform an operation on the body 2, to facilitate input when the user uses the electronic device 100.

Refer to FIG. 1. The electronic device 100 may further include a rotating shaft mechanism 3. The rotating shaft mechanism 3 is located at a connection between the screen member 1 and a base 21, and the screen member 1 is in rotating connection with the base 21 through the rotating shaft mechanism 3. The screen member 1 is rotated, so that a configuration of the electronic device 100 may be changed. For example, the screen member 1 is rotated, so that the electronic device 100 may be switched from a closed state to an open state (as shown in FIG. 1). For another example, the screen member 1 is rotated, so that the electronic device 100 may be switched from the open state to the closed state. When the electronic device 100 is in the closed state, the screen member 1 is folded on the base 21. When the electronic device 100 is in the open state, the screen member 1 is arranged at an angle relative to the body 2.

In some embodiments, the screen member 1 may be arranged on the body 2, and can be separated from the body 2. For example, the screen member 1 may be arranged on the body 2 through magnetic attraction, to facilitate separation of the screen member 1 from the body 2. After the screen member 1 is separated from the body 2, the screen member 1 and the body 2 may be two apparatuses independent from each other. The screen member 1 may be used alone. A location of the screen member 1 relative to the body 2 is changed, so that use requirements of the user in more application scenarios can be satisfied.

The structure of the electronic device 100 is further described below by using the notebook computer shown in FIG. 1 in which the screen member 1 is in rotating connection with the base 21 as an example.

Still refer to FIG. 1. The screen member 1 may include a screen housing 11 and a display screen 12. The display screen 12 is assembled on the screen housing 11, and forms the screen member 1 with the screen housing 11. When the display screen 12 is assembled on the screen housing 11, the display screen 12 is exposed on a surface of the screen housing 11 facing the body 2, so that the display screen 12 may be configured to display information and provide an interactive interface for the user.

Still refer to FIG. 1. The screen member 1 further includes a camera module (not shown) and the like. The camera module is located in the screen housing 11, to implement assembly of the camera module on the screen member 1.

Still refer to FIG. 1. The body 2 includes the base 21. The electronic device 100 includes a housing, and the housing includes the base 21 and the screen housing 11. The rotating shaft mechanism 3 is located between the screen housing 11 and the base 21, and the screen housing 11 is in rotating connection with the base 21 through the rotating shaft mechanism 3, to implement a rotating connection between the screen member 1 and the body 2. In this way, the screen housing 11 is rotated, so that the electronic device 100 can be switched between an open state and a closed state.

A surface of the screen housing 11 facing away from the display screen 12 forms a surface A of the electronic device 100. A surface of the screen member 1 on which the display screen 12 is arranged forms a surface B of the electronic device 100.

Still refer to FIG. 1. The input apparatus on the body 2 may include a keyboard 22. The keyboard 22 includes a language input module, a number input module, a symbol input keyboard 22, and the like. The keyboard 22 is mounted on a side of the base 21 facing the display screen 12, to implement assembly of the keyboard 22 on the base 21. The user may perform an operation on the keyboard 22, to facilitate input when the user uses the electronic device 100.

In addition to the keyboard 22, the input apparatus on the body 2 may further include a touch pad 23. As another input module in the electronic device 100, the touch pad 23 may alternatively be mounted on a surface of the base 21 facing the display screen 12, to send a command input data, or the like to the electronic device 100. The touch pad 23 on the base 21 may be arranged on a side of the touch pad 23 away from the rotating shaft mechanism 3, so that when the user uses the electronic device 100, the touch pad 23 can be close to the user, thereby facilitating use of the user on the touch pad 23.

A surface of the base 21 on which the keyboard 22 and the touch pad 23 are arranged forms a surface C of the electronic device 100, and a surface of the base 21 opposite to the keyboard 22 or the touch pad 23 forms a surface D of the electronic device 100.

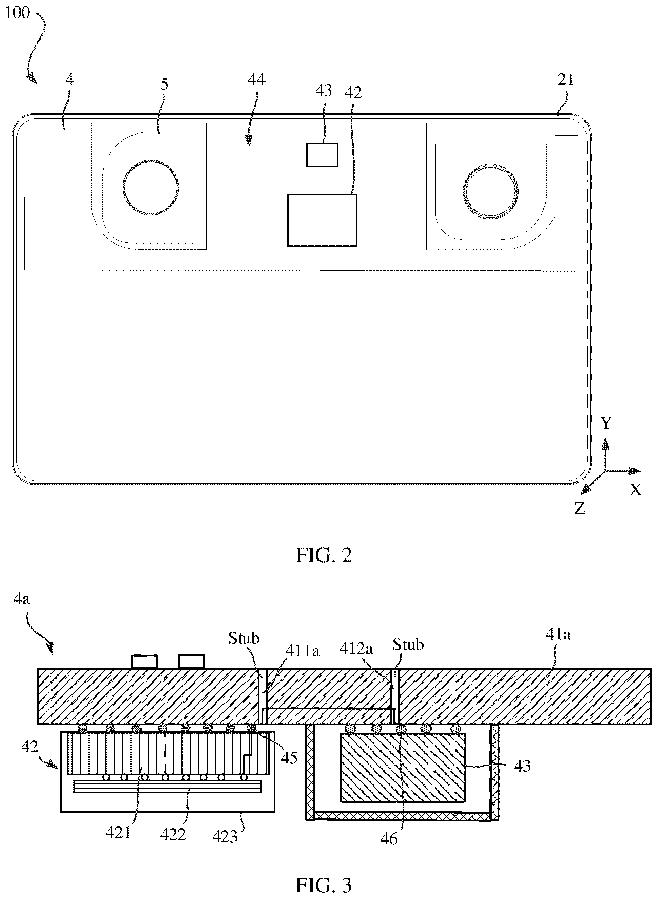

FIG. 2 is a schematic diagram of an internal structure of a body 2 of an electronic device 100. Refer to FIG. 2. The electronic device 100 further has a circuit board 4. The circuit board 4 may be arranged in the base 21, to implement mounting of the circuit board 4 in the body 2. The circuit board 4 includes a circuit board body 41 (not shown) and a large quantity of electronic components. For ease of description below, a length direction of the circuit board body 41 is defined as a direction X, a width direction of the circuit board body 41 is defined as a direction Y, and a thickness direction of the circuit board body 41 is defined as a direction Z. The large quantity of electronic components (not shown in the figure) are usually arranged on the circuit board body 41, to implement a control function of the circuit board 4 for the electronic device 100. For example, the circuit board 4 may be connected to the display screen 12, to implement a display control function for the display screen 12.

The large quantity of electronic components include a processor, a memory, and an electrical connector. For example, the processor may include a central processing unit (central processing unit, CPU) 42, an application processor (application processor, AP), a modem processor, a graphics processing unit (graphics processing unit, GPU), an image signal processor (image signal processor, ISP), a controller, a video codec, a digital signal processor (digital signal processor, DSP), a baseband processor, a display process unit (display process unit, DPU), and the like.

The processor (for example, the central processing unit 42) may be electrically connected to the display screen 12 through the electrical connector on the circuit board body 41, so that a signal between the processor and the display screen 12 may be transmitted between the processor and the display screen 12, thereby implementing a display control function of the processor for the display screen 12. The electrical connector may be an electrically-connected socket or the like.

The memory may be configured to store computer executable program code, data (for example, audio data and an address book) created during use of the electronic device 100, and the like. The executable program code includes instructions. The memory may include a high-speed random access memory, a non-volatile memory, or the like. For example, the high-speed random access memory may include a double data rate synchronous dynamic random access memory (DDR, random access memory 43 for short). For example, the non-volatile memory may include a flash memory or the like.

The processor is electrically connected to the memory, so that transmission of a signal between the processor and the memory may be implemented. For example, when the processor (for example, the central processing unit 42) is electrically connected to the memory, the memory can store instructions or data just used or cyclically used by the processor, and the processor can also execute various functional applications and data processing of the electronic device 100 by running the instructions stored in the memory.

In addition to the processor, the memory, and the electrical connector, the circuit board 4 further carries electronic components such as a power management module and a charging management module. The electronic components carried on the circuit board 4 are not further described herein.

Because at least a large part of processors are heat generating components, a large amount of heat is generated during operation of the processor. For example, the processors such as the central processing unit 42, the graphics processing unit, and the application processor are heat generating components, and generate a large amount of heat during operation. Therefore, when the electronic components are arranged on the circuit board 4, the heat generating components such as the processors are arranged in a centralized manner, so that heat of the heat generating components such as the processors is dissipated by using a heat dissipation system in the body 2, to ensure normal use of the electronic device 100.

A region, on the circuit board body 41, in which the processors are arranged in the centralized manner is referred to as a core region 44 of the circuit board 4. The heat dissipation system may include an active heat dissipation member and a passive heat dissipation member. The passive heat dissipation member may include a heat pipe, a vapor chamber, and the like. The passive heat dissipation member is mainly configured to be arranged on the heat generating components, and passively absorb heat from the heat generating components, to implement heat dissipation for the heat generating components. The active heat dissipation member may include a fan 5. The fan 5 can carry away the heat from the passive heat dissipation member, so that the passive heat dissipation member continuously dissipates the heat from the heat generating components. The fan 5 is usually arranged on a side of the circuit board body 41. Two fans 5 may be provided. The core region 44 of the circuit board 4 may be located in a region of the circuit board body 41 between the two fans 5.

As a core component of the electronic device 100, the circuit board 4 plays an important role in the electronic device 100. Performance of the circuit board 4 directly affects performance of the electronic device 100.

FIG. 3 shows an example of a partial structure of a first circuit board in the core region 44 in the conventional technologies. Refer to FIG. 3. The circuit board body 41a is a wiring board carrying electronic components on a circuit board 4a. On the premise of ensuring transmission of a signal between electronic components carried on the circuit board 4a, limited by manufacturing costs of the electronic device 100, the circuit board body 41a in the circuit board 4a is mostly provided with signal holes. The signal holes in the circuit board body 41a are signal vias. A signal between the electronic components carried on the circuit board 4a may be transmitted through the signal holes. The signal via may be a metal via on the circuit board body 41a. The metal via may be understood as a through hole that is on the circuit board body 41a and plated with a conductive metal. For example, the conductive metal may be copper or the like.

For example, still refer to FIG. 3. For ease of an electrical connection between the random access memory 43 and the central processing unit 42, the random access memory 43 is also arranged in the core region 44 (not shown), so that transmission of a signal between the central processing unit 42 and the random access memory 43 can be implemented through a signal hole on the circuit board 4.

Still refer to FIG. 3. The central processing unit 42 may include a base board 421, a chip 422, and an encapsulation layer 423. The chip 422 is soldered to the base board 421. The encapsulation layer 423 is encapsulated on outer sides of the chip 422 and the base board 421. The base board 421 is soldered to the circuit board body 41a through a plurality of first connection portions 45. The first connection portion 45 is a soldering portion. For example, the soldering portion may include a pad and a solder ball on the pad. The random access memory 43 and the central processing unit 42 may be arranged on the same surface of the circuit board body 41a. The random access memory 43 is soldered to the circuit board body 41a through a plurality of second connection portions 46. The second connection portion 46 is the foregoing soldering portion.

On the circuit board body 41a, a first signal hole 411a is provided at a location corresponding to the first connection portion 45, and a second signal hole 412a is provided at a location corresponding to the second connection portion 46. The central processing unit 42 is in conduction with the random access memory 43 through the first connection portion 45, the first signal hole 411a, the second signal hole 412a, and the second connection portion 46, to implement the electrical connection between the central processing unit 42 and the random access memory 43, thereby facilitating transmission of a signal (random access memory signal for short) between the central processing unit 42 and the random access memory 43.

The first connection portion 45, the first signal hole 411a, the second signal hole 412a, and the second connection portion 46 may form a transmission path between the central processing unit 42 and the random access memory 43. The transmission path is used for transmission of the random access memory signal between the central processing unit 42 and the random access memory 43.

FIG. 3 shows only one transmission path between the central processing unit 42 and the random access memory 43, and does not constitute a limitation on a quantity of transmission paths between the central processing unit 42 and the random access memory 43. A plurality of random access memory signals are provided. A plurality of transmission paths between the central processing unit 42 and the random access memory 43 are provided, so that each random access memory signal can be transmitted through one transmission path. In this case, the central processing unit 42 may be electrically connected to the random access memory 43 through a plurality of first connection portions 45. The plurality of first connection portions 45 are evenly arranged on the circuit board body 41 along a peripheral side of the central processing unit 42. Each first connection portion 45 is provided with one first signal hole 411, one second signal hole 412, and one second connection portion 46 correspondingly, to form the plurality of transmission paths between the central processing unit 42 and the random access memory 43. One first connection portion 45, one first signal hole 411, one second signal hole 412, and one second connection portion 46 are correspondingly arranged in each signal transmission path. In this application, the quantity of transmission paths between the central processing unit 42 and the random access memory 43 is not specifically limited. The transmission of the random access memory signal is further described below by using one transmission path as an example.

Limited by manufacturing costs of the circuit board 4a, the first signal hole 411a is usually arranged in a blank region of the circuit board body 41a on a side of the first connection portion 45, and the second signal hole 412a is usually arranged in a blank region of the circuit board body 41a on a side of the second connection portion 46. The first signal hole 411a is arranged corresponding to the first connection portion 45, is connected to the corresponding first connection portion 45, and is connected to the second signal hole 412a through a working layer 413 (not shown) inside the circuit board body 41a. The second signal hole 412a is further arranged corresponding to the second connection portion 46, and is connected to the corresponding second connection portion 46. In this way, the central processing unit 42 is in conduction with the random access memory 43 through the first connection portion 45, the first signal hole 411a, the second signal hole 412a, and the second connection portion 46.

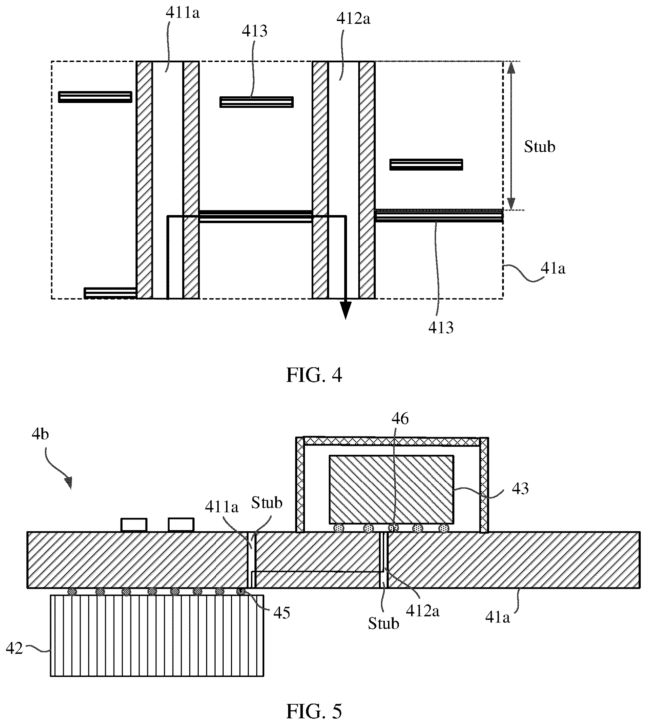

FIG. 4 shows an example of a partial detailed diagram of the circuit board body 41a in FIG. 3 at the first signal hole 411a and the second signal hole 412a. Refer to FIG. 4. The conventional circuit board body 41a includes a plurality of stacked working layers 413. The working layers 413 include copper layers located on a top layer and a bottom layer of the circuit board body 41a. The working layers 413 further include a middle layer located in the circuit board body 41a. For example, the middle layer may be a circuit layer or the like. Adjacent working layers 413 are insulated from each other. A signal hole passes through each working layer 413. Each first signal hole 411a may be connected to the second signal hole 412a through the middle layer in the circuit board body 41a.

When the random access memory signal is transmitted in the first signal hole 411a, the random access memory signal passes through only a part of the working layers 413 of the circuit board body 41a in the first signal hole 411, and the first signal hole 411a is excessively long.

A stub is formed in the first signal hole 411a due to a working layer 413 through which the random access memory signal does not pass. The stub reflects a high-speed signal in the first signal hole 411a, causing degradation of quality of the high-speed signal. For example, in some examples, the high-speed signal may be understood as a signal whose rate is greater than 2G. In some examples, the rate of the high-speed signal may alternatively be defined by using another defining condition (for example, a rate is greater than 5G). In this application, the electronic device 100 is further described by using an example in which a signal whose rate is greater than 2G is a high-speed signal.

The random access memory signal is a high-speed signal. Therefore, the stub seriously worsens degradation of quality of the random access memory signal. Consequently, the rate of the random access memory 43 cannot be increased to a maximum rate that can be supported by the electronic device 100, limiting improvement of performance of the circuit board 4a.

Similarly, when the random access memory signal is transmitted in the second signal hole 412a, because the random access memory signal passes through only a part of the working layer 413 of the circuit board body 41a in the second signal hole 412a, a stub is formed in the second signal hole 412a due to a working layer 413 through which the random access memory signal does not pass, resulting in deterioration of the quality of the random access memory signal.

FIG. 5 is a partial schematic diagram of a second circuit board in the core region 44 (not shown) in the conventional technologies. Refer to FIG. 5. A difference between a second circuit board 4 and the first circuit board (the circuit board 4a) in FIG. 3 lies in that, the random access memory 43 in the second circuit board (the circuit board 4b) is soldered to a surface of the circuit board body 41a opposite to the central processing unit 42 through the second connection portion 46. In other words, the random access memory 43 and the central processing unit 42 are arranged on different surfaces of the circuit board body 41a. Similarly, when the random access memory 43 and the central processing unit 42 are arranged on different surfaces of the circuit board body 41a, two technical problems of the first circuit board 4 (the circuit board 4a) also exist, resulting in deterioration of quality of the random access memory signal.

FIG. 3 and FIG. 5 both show a conventional arrangement of the conventional random access memory 43 on the circuit board body 41. In the conventional arrangement, a spacing between adjacent second connection portions 46 on the circuit board body 41a is large, so that the second signal hole 412a can be provided on the circuit board body 41a.

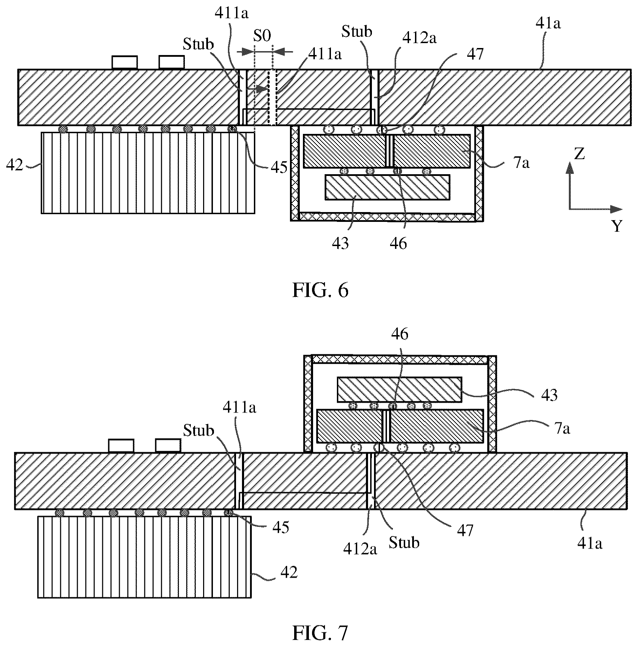

FIG. 6 is a partial schematic diagram of a circuit board assembly in the conventional technologies. FIG. 6 shows a non-conventional arrangement of the conventional random access memory 43 on the circuit board body 41a. Refer to FIG. 6. Compared with the foregoing first circuit board (the circuit board 4a) and the second circuit board (the circuit board 4b), a quantity of second connection portions 46 between the random access memory 43 and the circuit board body 41a is increased, and the spacing between adjacent second connection portions 46 is small.

As described above, the second signal hole 412a is usually arranged in the blank region of the circuit board body 41a on the side of the second connection portion 46. When the spacing between adjacent second connection portions 46 is small, a space between adjacent second connection portions 46 on the circuit board body 41a is not enough to provide the second signal hole 412a.

Therefore, still refer to FIG. 6. In the non-conventional arrangement, the random access memory 43 is connected to the circuit board body 41a through a transit board 7a. The second connection portion 46 may be located between the transit board 7a and the random access memory 43. The circuit board body 41a is connected to the transit board 7a through a third connection portion 47. The third connection portion 47 is the foregoing soldering portion. For example, each second signal hole 412a corresponding to the circuit board body 41a is provided with the third connection portion 47 correspondingly. The second signal hole 412a is connected to the corresponding third connection portion 47. The transit board 7a has a signal channel (not shown) at each third connection portion 47. The second signal hole 412a is electrically connected to the random access memory 43 through the corresponding third connection portion 47, the signal channel in the transit board 7a, and the second connection portion 46, to implement transmission of the random access memory signal between the second connection portion 46 and the second signal hole 412a.

Refer to FIG. 6. When the random access memory 43 is connected to the circuit board body 41a through the transit board 7a, the random access memory 43 may be connected, through the transit board 7a, to a surface of the circuit board body 41a on which the central processing unit 42 is arranged. In other words, the random access memory 43 and the central processing unit 42 may be arranged on the same surface of the circuit board body 41a.

Considering heat dissipation of the central processing unit 42 and user experience of the electronic device 100, when the circuit board body 41a is arranged in the body 2, the central processing unit 42 is usually arranged on a side of the circuit board body 41a facing the surface D of the electronic device 100.

FIG. 7 is a partial schematic diagram of another circuit board assembly provided in the conventional technologies. Refer to FIG. 7. When the random access memory 43 is connected to a surface of the circuit board body 41a opposite to the central processing unit 42 through the transit board 7a, that is, when the random access memory 43 and the central processing unit 42 are arranged on different surfaces of the circuit board body 41a, the random access memory 43 faces the surface C of the electronic device 100, so that the random access memory 43 is excessively close to the keyboard 22.

When a thickness of the body 2 remains unchanged, when the random access memory 43 is excessively close to the keyboard 22, a distance between the random access memory 43 and the keyboard 22 does not satisfy a design requirement on the electronic device 100. Therefore, when the random access memory 43 is connected to the circuit board body 41a through the transit board 7a, the random access memory 43 and the central processing unit 42 are usually arranged on the same surface of the circuit board body 41a, so that the random access memory 43 faces the surface D of the electronic device 100.

Similarly, when the random access memory 43 is connected to the circuit board body 41 through the transit board 7a, two technical problems of the first circuit board (the circuit board 4a) also exist, resulting in deterioration of the quality of the random access memory signal.

In the conventional technologies, a back-drilling process is usually used to eliminate a stub conventional in the circuit board body 41a.

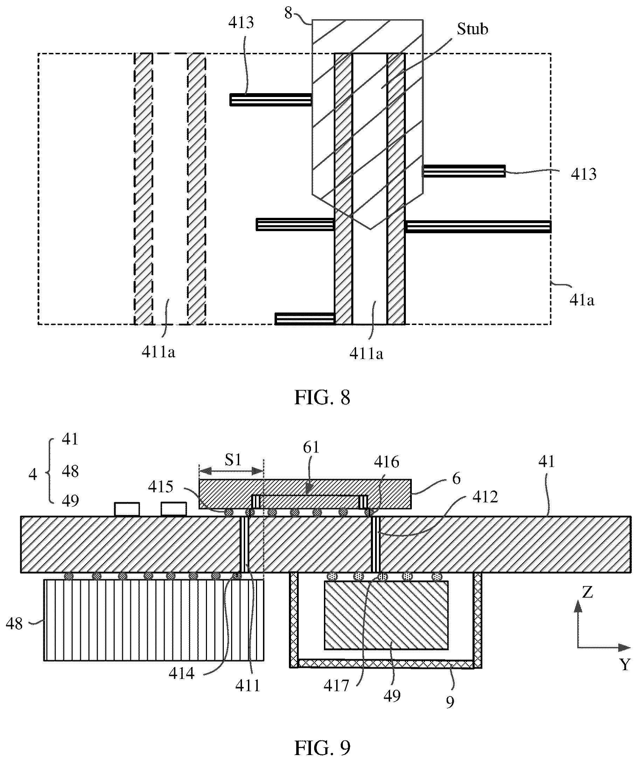

By using the circuit board assembly in FIG. 6 as an example, FIG. 8 is a schematic diagram of a structure of eliminating a stub on the circuit board body 41a through back-drilling. Refer to FIG. 8. The first signal hole 411a is used as an example to briefly describe a process of eliminating a stub in a signal hole through back-drilling. Still refer to FIG. 8. In the back-drilling process, a size of a drill bit 8 is larger than a size of the first signal hole 411a, and the drill bit 8 may be located at one end (a useless end) of the circuit board body 41a at which a stub is generated in the first signal hole 411a. The drill bit 8 is used to drill the circuit board body 41a, so that the stub generated in the first signal hole 411a may be eliminated. Similarly, a stub generated in the second signal hole 412a can also be eliminated through the back-drilling process.

However, the back-drilling process cannot be widely used on the electronic device 100 such as the notebook computer. Specifically, there are three reasons.

The first reason is that, limited by alignment precision of the conventional drill bit 8 on the signal hole on the circuit board body 41a, a size of a drilled hole formed by the drill bit 8 on the circuit board body 41a is larger than a preset size of the drilled hole. To prevent the drill bit 8 from not damaging a working layer 413 of the circuit board body 41a on a peripheral side of the drilled hole during drilling, a distance between the signal hole and the surrounding working layer 413 needs to be enlarged at an early stage of arranging the circuit board body 41a. In this way, the drill bit 8 needs a large space on the circuit board body 41a in the back-drilling process. When a large space is required on the circuit board body 41 in the back-drilling process, an area of the circuit board 4 in the core region 44 is excessively large. The size of the circuit board in the core region 44 needs to be coupled to a size of the passive heat dissipation member. However, a requirement on the electronic device 100 is that the size of the circuit board in the core region 44 is as small as possible. In this way, the use of the back-drilling process does not satisfy the requirement on the electronic device 100.

Still refer to FIG. 8 and FIG. 6. The second reason is that, when a distance between the signal hole and the surrounding working layer 413 needs to be increased due to the back-drilling process, a distance between two adjacent signal holes of the circuit board body 41a is increased. For example, when a distance between two adjacent first signal holes 411a is increased, a part of the plurality of first signal holes 411a move toward a side of the random access memory 43 along a width direction (the direction Y) of the circuit board body 41a, and then the random access memory 43 moves toward a side away from the central processing unit 42 along the Y direction. A design area required by the random access memory 43 on the circuit board body 41 is increased, so that a distance between the random access memory 43 and the central processing unit 42 is increased.

When the random access memory 43 is away from the central processing unit 42, an insertion loss of the random access memory signal is increased, resulting in deterioration of quality of the random access memory signal.

The third reason is that, in a process of manufacturing the circuit board body 41a, an additional process is required to perform the back-drilling process, which causes an increase in manufacturing costs of the circuit board.

In conclusion, the back-drilling process cannot be widely applied to the electronic device 100 such as the notebook computer. The problem of the deterioration of the quality of the random access memory signal caused by the stub, the random access memory 43, and the central processing unit 42 is still not resolved effectively.

Therefore, an embodiment of this application provides a circuit board assembly. FIG. 9 is a schematic diagram of a structure of a first circuit board assembly according to this application. Refer to FIG. 9. A connection board 6 is added to the circuit board assembly, so that a first electronic component 48 may be in conduction with a second electronic component 49 through a first signal hole 411 in a circuit board body 41 and the connection board 6. In this way, when transmission of a signal (second electronic component signal for short) between the first electronic component 48 and the second electronic component 49 is implemented, the first signal hole 411 can be fully used (100% used) during transmission of the second electronic component signal, to avoid generation of a stub in the first signal hole 411. Therefore, according to the circuit board assembly in this application, a back-drilling process is not required, so that the second electronic component 49 is close to the first electronic component 48. In this way, when quality of the signal between the first electronic component 48 and the second electronic component 49 is improved and better performance of the second electronic component 49 is ensured, a technical problem caused by the back-drilling process is effectively resolved.

The first electronic component 48 may include a processor. For example, the first electronic component 48 may include the central processing unit 42 or the like. The second electronic component 49 may include a memory. For example, the second electronic component 49 may include the random access memory 43 (DDR) or another memory having a high-speed signal. Because of introduction of the connection board 6 in the circuit board assembly, a stub is not generated in the first signal hole 411. In this way, the second electronic component 49 can be arranged close to the first electronic component 48, quality of the random access memory signal can be improved, and performance of the random access memory 43 can be improved. In this way, a rate of the random access memory 43 can be increased to a maximum rate that can be supported by the electronic device 100, and better performance of the random access memory 43 can be ensured, thereby improving performance of the circuit board assembly.

Therefore, in this application, when the first electronic component 48 is the central processing unit 42 and the second electronic component 49 is the random access memory 43, technical problems caused by the back-drilling process such as an excessively large area of the circuit board 4 in the core region 44 and a long distance between the random access memory 43 and the central processing unit 42 can be effectively resolved.

It should be noted that in addition to the memory, the second electronic component 49 may further include another electronic component in the electronic device 100. For example, the second electronic component 49 may further include a connector or the like. The connector is configured to connect to the display screen 12. In this way, when the display screen 12 is electrically connected to the first electronic component 48 through the connector, an electrical connection between the display screen 12 and the first electronic component 48 can be implemented, and quality of the second electronic component signal can be improved, thereby improving connection performance between the circuit board assembly and the display screen 12.

The structure of the circuit board assembly in this application is further described below by using an example in which the first electronic component 48 is the central processing unit 42 and the second electronic component 49 is the random access memory 43.

The circuit board assembly in this application is arranged in the housing of the electronic device, so that when the circuit board assembly is assembled in the electronic device, performance of the circuit board assembly can, and manufacturing costs of the circuit board assembly can be reduced. Specifically, the circuit board assembly may be arranged in the base 21 of the body 2.

Still refer to FIG. 9. The circuit board assembly includes the circuit board 4. The circuit board 4 has the circuit board body 41 and the first electronic component 48. The first electronic component 48 is located on the circuit board body 41. The circuit board body 41 has the signal hole. The signal hole includes the first signal hole 411. The circuit board assembly further includes the connection board 6. The connection board 6 is located on a side of the circuit board body 41 opposite to the first electronic component 48, and is in conduction with the first electronic component 48 through the first signal hole 411, thereby implementing transmission of the second electronic component signal between the first electronic component 48 and the connection board 6 through the first signal hole 411.

The circuit board assembly further includes the second electronic component 49. The second electronic component 49 is in conduction with the connection board 6. Because the connection board 6 is in conduction with the first electronic component 48, when the second electronic component 49 is in conduction with the connection board 6, the first electronic component 48 can be electrically connected to the second electronic component 49 through the connection board 6 and the first signal hole 411, thereby implementing transmission of the second electronic component signal between the first electronic component 48 and the second electronic component 49.

Because the connection board 6 is located on the side of the circuit board body 41 opposite to the first electronic component 48, when the signal of the second electronic component 49 is transmitted in the circuit board body 41 and passes through the first signal hole 411, the second electronic component signal can completely pass through the first signal hole 411. In this way, a first signal is fully used (100% used), and a stub is not generated in the first signal hole 411, to avoid deterioration of the quality of the second electronic component signal due to the stub, thereby improving the quality of the second electronic component signal.

Because of introduction of the connection board 6, the stub is not generated in the first signal hole 411, in the circuit board assembly in this application, the back-drilling process is not required, and a distance between a first signal hole 411 and a surrounding working layer 413 in the circuit board body 41 does not need to be increased. Therefore, in the circuit board assembly of the circuit board 4 of this application, there is no problem that the area of the circuit board 4 in the core region 44 is excessively large and a design area required by the second electronic component 49 is increased.

Compared with the foregoing first circuit board 4, the second circuit board 4, the first circuit board assembly, and the second circuit board assembly, in the circuit board assembly in this application, the second electronic component 49 is closer to the first electronic component 48, which can reduce an insertion loss of the second electronic component signal and improve the quality of the random access memory signal.

Therefore, according to the circuit board assembly in this application, better performance of the second electronic component 49 can be ensured, thereby improving performance of the second electronic component 49 and the circuit board assembly.

Still refer to FIG. 9. The circuit board body 41 has a first surface and a second surface in a board thickness direction. In other words, the first surface and the first surface are two surfaces of the circuit board body 41 that are opposite to each other in the board thickness direction. For the board thickness direction of the circuit board body 41, refer to the direction Z. The direction Z is perpendicular to the foregoing direction Y. The second surface faces the keyboard 22 of the electronic device 100. Because the first surface and the first surface are the two opposite surfaces of the circuit board body 41 and the second surface is away from the keyboard 22, the second surface faces the surface D of the electronic device 100.

The first electronic component 48 is arranged on the first surface, and the connection board 6 is arranged on the second surface, so that the connection board 6 is located on the side of the circuit board body 41 opposite to the first electronic component 48, to ensure that the connection board 6 can be in conduction with the first electronic component 48 through the first signal hole 411. In addition, because the first electronic component 48 is arranged on the first surface, a location of the first electronic component 48 on the circuit board body 41 is not changed in the circuit board assembly in this application, so that when heat of the first electronic component 48 is dissipated, user experience of the electronic device 100 can be ensured.

Still refer to FIG. 9. The connection board 6 is a high density interconnector (high density interconnector, HDI). A first signal channel 61 is provided in the connection board 6. A first end of the first signal channel 61 is in conduction with the first electronic component 48 through the first signal hole 411, and a second end of the first signal channel 61 is in conduction with the second electronic component 49. When the second electronic component signal is transmitted in the first signal channel 61, a stub is not generated in the first signal channel 61 of the connection board 6. In this way, the connection board 6 implements conduction between the first electronic component 48 and the second electronic component 49 through the first signal channel 61, to ensure that when the first electronic component 48 is electrically connected to the second electronic component 49, the first signal hole 411 and the first signal channel 61 can be fully used to implement transmission of the second electronic component signal, and a stub is not generated in the first signal hole 411 and the first signal channel 61, thereby further improving the quality of the second electronic component signal.

To resolve that the second electronic component signal generates the stub in the first signal hole 411, the high density interconnector may alternatively be used for the circuit board body 41. However, this may cause excessively high manufacturing costs of the circuit board assembly. Compared with the manner of using the circuit board body 41 for the high density interconnector in which the connection board 6 is only a small board arranged on the circuit board body 41 due to a small size of the connection board 6, in this application, the connection board is arranged, so that when the second electronic component signal is prevented from generating the stub in the first signal hole 411, the entire circuit board body 41 does not need to use the high density interconnector, thereby reducing manufacturing costs of the circuit board assembly.

Still refer to FIG. 9. A first conduction portion 414 is provided between the first electronic component 48 and the circuit board body 41. The first electronic component 48 is connected to a first end of the first signal hole 411 through the first conduction portion 414. A second conduction portion 415 is provided between the connection board 6 and the circuit board body 41. A second end of the first signal hole 411 is connected to a first end of the first signal channel 61 through the second conduction portion 415. The first electronic component 48 can be in conduction with the first end of the first signal channel 61 through the first conduction portion 414 and the second conduction portion 415. In this way, when the second end of the first signal channel 61 is in conduction with the second electronic component 49, the first electronic component 48 can be in conduction with the second electronic component 49, thereby implementing transmission of the second electronic component signal between the first electronic component 48 and the second electronic component 49.

When the connection board 6 is not introduced, a first signal hole 411 corresponding to an outer first conduction portion 414 needs to be moved to an outer side of the first electronic component 48 along the direction Y, to reserve a sufficient cabling channel between an inner first conduction portion 414 and a corresponding first signal hole 411. In this way, a signal fan-out area S0 of the first electronic component 48 is large, and the second electronic component 49 moves away from the second electronic component 49 along the direction Y. In this way, the second electronic component 49 is far away from the first electronic component 48, and an insertion loss of the second electronic component signal is large.

The first electronic component 48 has a first projection region on the circuit board body 41. The signal fan-out area S0 of the first electronic component 48 may be understood as an area of the first signal hole 411 outside the first projection region on the circuit board body 41.

Because of the introduction of the connection board 6, the first conduction portion 414 may be directly connected to the first end of the first signal hole 411, and the connection board 6 may be directly connected to the second end of the first signal hole 411 on a back surface of the circuit board body 41. In this way, cabling of the second electronic component signal between the first electronic component 48 and the second electronic component 49 is implemented through the circuit board 4, and the first signal hole 411 does not need to be partially moved to the outer side of the first electronic component 48. In this way, the signal fan-out area S0 of the first electronic component 48 can be reduced, and a distance between the first electronic component 48 and the second electronic component 49 can be further reduced, so that the second electronic component 49 is closer to the first electronic component 48, thereby further reducing an insertion loss of the signal between the first electronic component 48 and the second electronic component 49 and improving the quality of the second electronic component signal.

It should be noted that the first electronic component 48 is connected to the first signal hole 411 through the first conduction portion 414. A structure of the first conduction portion 414 is described below, and details are not described herein.

A plurality of soldering portions are provided between the first electronic component 48 and the circuit board body 41. The soldering portion may include a solder ball or a pad. For ease of description, the soldering portions between the first electronic component 48 and the circuit board body 41 are referred to as second soldering portions. The plurality of first soldering portions may be evenly arranged between the first electronic component 48 and the circuit board body 41. The first soldering portion may include a solder ball or a pad. A part of the plurality of first soldering portions are connected to the connection board 6, and the other part of the plurality of first soldering portions may be connected to other electronic components on the circuit board 4. The first soldering portion connected to the connection board 6 forms the first conduction portion 414, to implement a connection between the first electronic component 48 and the first end of the first signal hole 411 through the first soldering portion.

A plurality of soldering portions are provided between the connection board 6 and the circuit board body 41. For ease of description, the soldering portions between the connection board 6 and the circuit board body 41 are referred to as second soldering portions. The plurality of second soldering portions may be evenly arranged between the connection board 6 and the circuit board body 41. Similarly, the second soldering portion connected to the connection board 6 forms the second conduction portion 415, to connect the second end of the first signal hole 411 to the first end of the first signal channel 61 through the second soldering portion.

Still refer to FIG. 9. The first electronic component 48 has a first projection region on the circuit board body 41. A projection of the connection board 6 on the circuit board body 41 and the first projection region have a first overlapping region S1. The first signal hole 411 may be located in the first overlapping region S1, so that the signal fan-out area S0 of the first electronic component 48 may be zero, thereby reducing an insertion loss of the second electronic component signal as much as possible and improving the quality of the second electronic component signal.

It should be noted that when the insertion loss of the second electronic component signal is reduced, the first signal hole 411 may also be partially located outside the first projection region.

Because the first signal hole 411 is located in the first conduction portion 414, a forming process of the first signal hole 411 is complex. Therefore, in this application, the first signal hole 411 may be located on a side of the first conduction portion 414, and the first conduction portion 414 is directly connected to the first signal hole 411, so that when the first conduction portion 414 is connected to the first signal, the forming process of the first signal hole 411 can be simplified, and manufacturing costs of the circuit board assembly can be reduced.

A plurality of first conduction portions 414 are provided. Each first conduction portion 414 is provided with the first signal hole 411 and the second conduction portion 415 correspondingly. Each second conduction portion 415 of the connection board 6 is provided with the first signal channel 61 correspondingly. In this case, a plurality of transmission paths are formed between the first electronic component 48 and the second electronic component 49. Each transmission path includes one first conduction portion 414, one first signal hole 411, one second conduction portion 415, and one first signal channel 61. One second electronic component signal is transmitted in each transmission path, which can avoid mutual interference between second electronic component signals when a signal transmission rate is improved.

The structure of the circuit board assembly is further described below by using a transmission path as an example.

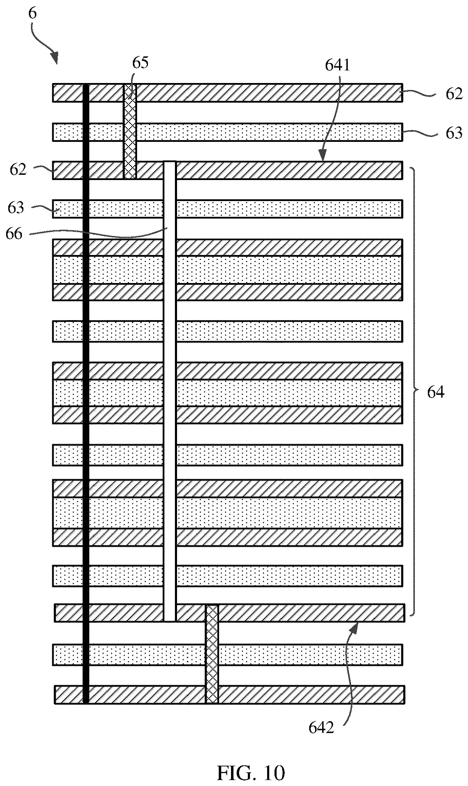

FIG. 10 is a schematic diagram of a structure of a connection board 6. Refer to FIG. 10. The connection board 6 includes a plurality of stacked conductive circuit layers 62. The conductive circuit layer 62 may be a conductive metal layer. For example, the conductive circuit layer 62 may be a copper layer. The plurality of conductive circuit layers 62 are stacked, and adjacent conductive circuit layers 62 are insulated from each other. At least four conductive circuit layers 62 are provided in the high density interconnector. Specifically, the connection board 6 further includes an insulation layer 63. The insulation layer 63 may be arranged between adjacent conductive circuit layers 62, to insulate the adjacent conductive circuit layers 62 from each other.

Still refer to FIG. 10. At least two conductive circuit layers 62 located in a middle layer of the connection board 6 form a core board unit 64 of the connection board 6. The connection board 6 further includes a conductive portion 65. A forming material of the conductive portion 65 may be a conductive metal. For example, the forming material of the conductive portion 65 may be copper or the like. Adjacent conductive circuit layers 62 located on a side of the chip 422 unit are interconnected through the conductive portion 65, so that interconnection between adjacent conductive circuit layers 62 is implemented through the conductive portion 65.

During manufacturing of the connection board 6, the conductive circuit layers 62 in the core board unit 64 may be pre-pressed, and then a conductive via is provided in the pressed core board unit 64, so that when the interconnection between adjacent conductive circuit layers 62 in the core board unit 64 is implemented through the conductive via, a signal can be transmitted in each of the conductive circuit layers 62 in the core board unit 64 through the conductive via. The conductive via in the core board unit 64 forms a signal buried via 66 in the connection board 6.

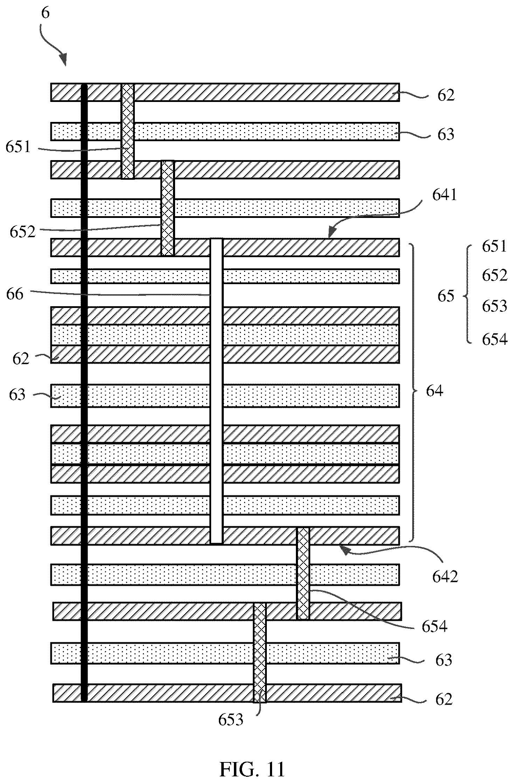

FIG. 11 is a schematic diagram of a structure of another connection board 6. When at least two conductive circuit layers 62 are arranged on any side of the core board unit 64, the plurality of conductive circuit layers 62 on any side of the core board unit 64 may be pressed on the side of the core board unit 64 layer by layer. Specifically, the core board unit 64 has a first side 641 and a second side 642 in a thickness direction. The core board unit 64 may be parallel to the direction Z in the thickness direction. The first side 641 of the core board unit 64 is arranged facing the top of the connection board 6, and the second side 642 of the core board unit 64 is arranged facing the bottom of the connection board 6. Conductive circuit layers 62 located on the first side 641 of the core board unit 64 may form a top region of the connection board 6. Conductive circuit layers 62 located on the second side 642 of the core board unit 64 may form a bottom region of the connection board 6.

A laser hole (not shown) is provided in adjacent conductive circuit layers 62 connected through the conductive portion 65. A forming material of the conductive portion 65 may be filled in the laser hole of the adjacent conductive circuit layers 62 through a process such as electroplating, to form the conductive portion 65.

A plurality of conductive portions 65 are provided in the connection board 6. According to locations of the plurality of conductive portions 65, for ease of description, the conductive portions 65 are defined as a first conductive portion 651, a second conductive portion 652, a third conductive portion 653, a fourth conductive layer, and a fifth conductive portion 655.

The first conductive portion 651 is arranged between adjacent conductive circuit layers 62 in the top region, to implement interconnection between the adjacent conductive circuit layers 62 in the top region through the first conductive portion 651. A conductive circuit layer 62 adjacent to the core board unit 64 in the top region is interconnected to a conductive circuit layer 62 on a surface layer of the core board unit 64 through the second conductive portion 652, to implement interconnection between the conductive circuit layer 62 in the top region and the first side 641 of the core board unit 64.

The third conductive portion 653 is arranged between adjacent conductive circuit layers 62 in the bottom region, to implement interconnection between the adjacent conductive circuit layers 62 in the bottom region through the third conductive portion 653. A conductive circuit layer 62 adjacent to the core board unit 64 in the bottom region is interconnected to a conductive circuit layer 62 located on a surface layer of the core board unit 64 through the fourth conductive portion 654, to implement interconnection between the conductive circuit layer 62 in the bottom region and the second side 642 of the core board unit 64.

For the manufacturing process of the high density interconnector, refer to related descriptions in the conventional technologies. Details are not described herein.

A quantity of conductive circuit layers 62 in the core board unit 64 is N. N is an even number, and N is greater than or equal to 2. Both a quantity of conductive circuit layers 62 in the top region and a quantity of conductive circuit layers 62 in the bottom region are a. a is greater than or equal to 1. The quantity of conductive circuit layers 62 in the bottom region is the same as the quantity of conductive circuit layers 62 in the top region.

A model of the connection board 6 may be usually indicated as a+N+a. a may also represent pressing on a side of the core board unit 64 in this case, and may also be understood as an order of the connection board 6. A total quantity of the conductive circuit layers 62 in the connection board 6 is a sum of N and 2a. In the electronic device 100, the connection board 6 usually uses a high density interconnector including eight or ten conductive circuit layers 62.

The structure of the connection board 6 is further described below by using a ten-layer high density interconnector as an example.

When the model of the connection board 6 is 1+8+1, it represents that the connection board 6 is a one-order ten-layer high density interconnector. When the model of the connection board 6 is 2+6+2, it represents that the connection board 6 is a two-order ten-layer high density interconnector. When the model of the connection board 6 is 3+4+3, it represents that the connection board 6 is a three-order ten-layer high density interconnector. When the model of the connection board 6 is 4+3+4, it represents that the connection board 6 is a four-order ten-layer high density interconnector.

When the connection board 6 is the one-order ten-layer high density interconnector (as shown in FIG. 10), the quantity of the conductive circuit layers 62 in the core board unit 64 is large, and a length of the signal buried via 66 in the connection board 6 is large.

The connection board 6 in FIG. 11 is the two-order ten-layer high density interconnector. Refer to FIG. 11. Compared with the one-order ten-layer high density interconnector, when the connection board 6 is the two-order ten-layer high density interconnector, the length of the signal buried via 66 is reduced.

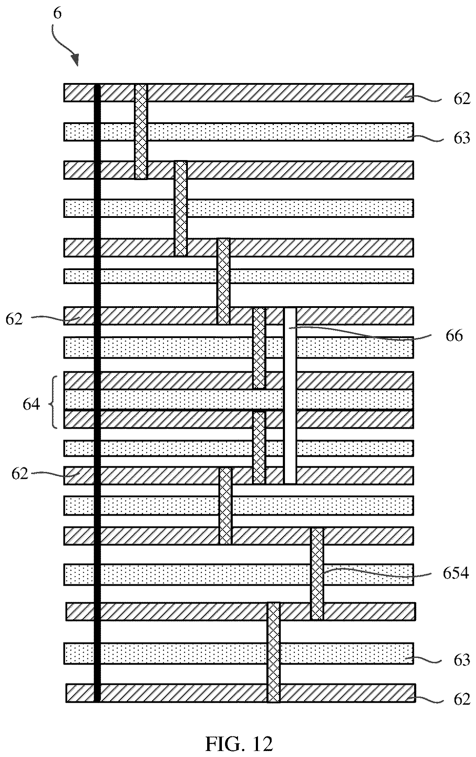

FIG. 12 is a schematic diagram of a structure of another connection board 6. The connection board 6 in FIG. 12 is the four-order ten-layer high density interconnector. Refer to FIG. 12. In the four-order ten-layer high density interconnector, the signal buried via 66 of the core board unit 64 extends into the conductive circuit layers 62 adjacent to the core board unit 64 in the top region and the bottom region. In this case, the conductive circuit layers 62 adjacent to the core board unit 64 in the top region and the bottom region may also be considered as a part of the core board unit 64. Refer to FIG. 12. Compared with the two-order ten-layer high density interconnector, when the connection board 6 is the four-order ten-layer high density interconnector, the length of the signal buried via 66 is reduced.

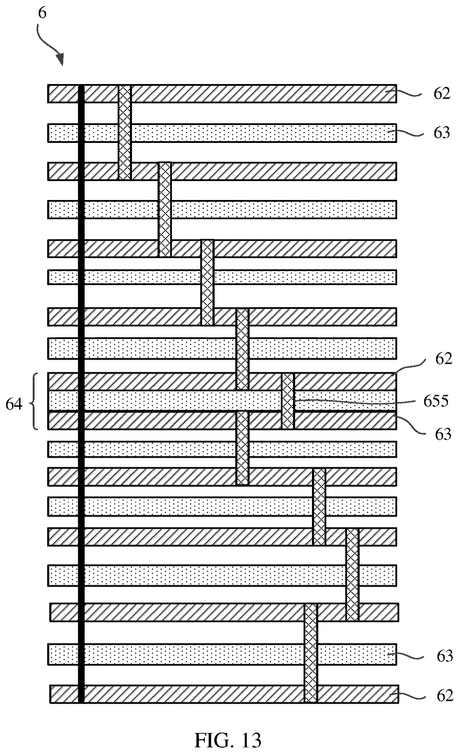

FIG. 13 is a schematic diagram of a structure of still another connection board 6. The connection board 6 in FIG. 13 is an any-order ten-layer high density interconnector. Refer to FIG. 13. When the connection board 6 is the any-order ten-layer high density interconnector, adjacent conductive circuit layers 62 in the core board unit 64 are interconnected through the conductive portion 65. For example, the adjacent conductive circuit layers 62 in the core board unit 64 are interconnected through the fifth conductive portion 655. In the any-order ten-layer high density interconnector, any conductive circuit layers 62 may be interconnected.

It can be seen that, under adjustment of the particular total quantity of the conductive circuit layers 62, when the order of the connection board 6 is small, a stub is easily generated during transmission of the second electronic component signal in the connection board 6.

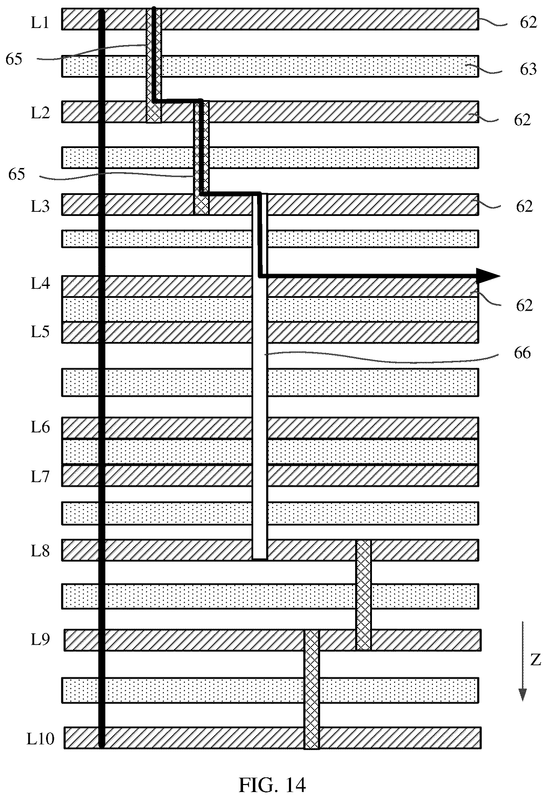

FIG. 14 is a schematic diagram of cabling of a signal in a low-order high density interconnector. The high density interconnector in FIG. 14 is the two-order ten-layer high density interconnector. Refer to FIG. 14. Along the direction Z, the ten conductive circuit layers 62 in the high density interconnector may be sequentially represented as L1, L2, L3, L4, L5, L6, L7, L8, L9, and L10. When a cabling layer of the second electronic component signal in the high density interconnector is the conductive circuit layer 62 L4, because the order of the high density interconnector is low, after the second electronic component signal passes through the conductive portion 65 between the conductive circuit layer 62 L1 and the conductive circuit layer 62 L2 and the conductive portion 65 between the conductive circuit layer 62 L2 and the conductive circuit layer 62 L3, the second electronic component signal further needs to pass through the signal buried via 66 to reach the conductive circuit layer 62 L4, and a stub is generated in the signal buried via 66.

Therefore, the circuit board body 41 in this application may include a one-step pressed through-hole wiring board. Alternatively, the circuit board body 41 in this application may include a low-order high density interconnector that is of a low order and in which a signal generates the stub in the signal buried via 66. For example, the circuit board body 41 may be a one-order or two-order high density interconnector. In other words, in the circuit board assembly in this application, the stub problem of the stub in the through-hole wiring board can be resolved, and the stub problem of the stub in the low-order high density interconnector can also be resolved.

When the circuit board body 41 is the one-step pressed through-hole wiring board, the signal hole may be the signal via in the circuit board body 41. When the circuit board body 41 is the low-order high density interconnector, the signal hole may be the signal buried via 66 in the circuit board body 41. Therefore, in this application, through the arrangement of the connection board 6, the problem of the stub generated in the signal via in the circuit board body 41 can be resolved, and the problem of the stub generated in the signal buried via 66 in the circuit board body 41 can also be resolved.

It should be noted that when the signal hole is the signal buried via 66, the signal hole is not exposed on a surface of the circuit board body 41. In this case, when the connection board 6 is in conduction with the first electronic component 48 and the second electronic component 49 through the signal hole, the conductive portion 65 in the circuit board body 41 is further needed.

Description is made by using an example of conduction between the connection board 6 and the first electronic component 48. When the connection board 6 is in conduction with the first electronic component 48, the first end of the first signal hole 411 of the first conduction portion 414 needs to be in conduction with the first soldering portion through the conductive portion 65 in the circuit board body 41, and the second end of the second signal hole 412 also needs to be connected to the second conduction portion 415 through the conductive portion 65 in the circuit board body 41.

The structure of the circuit board assembly in this application is further described below by using an example in which the circuit board body 41 is the through-hole wiring board (the signal hole is the signal via).

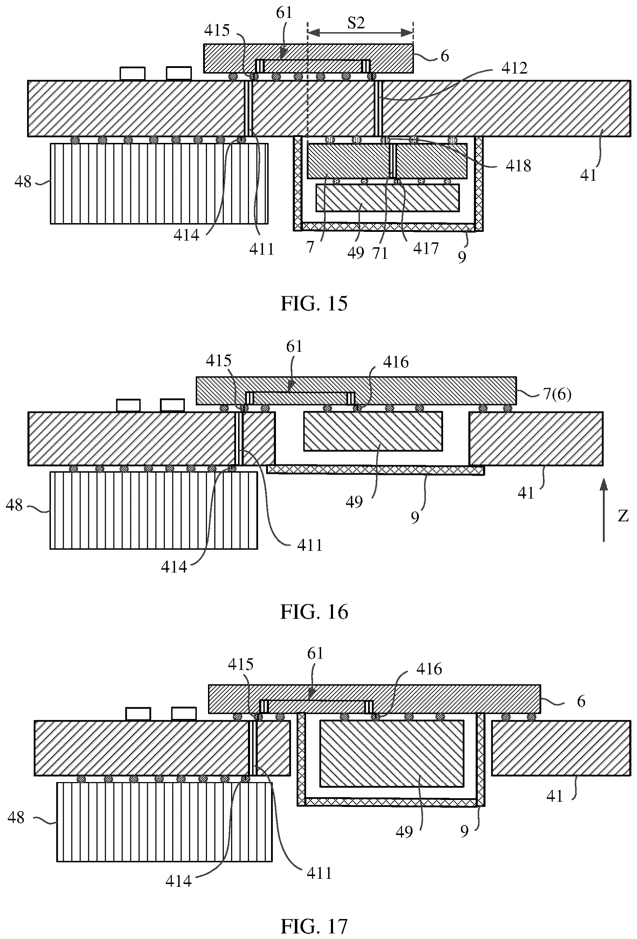

FIG. 15 is a schematic diagram of a structure of a second circuit board assembly according to this application. Refer to FIG. 15. The first signal channel 61 of the connection board 6 in this application is at least formed in the conductive portion 65 on a side of the core board unit 64 of the connection board 6 facing the circuit board body 41, so that the first signal channel 61 is formed by using the conductive portion 65 through which adjacent conductive circuit layers 62 are interconnected. In this way, when the second electronic component signal is transmitted in the first signal channel 61, the second electronic component signal can be prevented from passing through a useless conductive circuit layer 62 when passing through the first signal channel 61, thereby avoiding generation of a stub.

A quantity of conductive portions 65 in the first signal channel 61 depends on a location of the second electronic component 49 relative to the connection board 6, and also depends on a quantity of conductive circuit layers 62 occupied by the second electronic component signal during cabling of the second electronic component signal in the connection board 6. Description is further made below with reference to specific embodiments.

Still refer to FIG. 15. A third conduction portion 416 is provided between the second electronic component 49 and the connection board 6. For example, the third conduction portion 416 may be a soldering portion or the like. The third conduction portion 416 is connected between the second end of the first signal channel 61 and the second electronic component 49, so that the second electronic component 49 is in conduction with the connection board 6 through the third conduction portion 416, and the second electronic component signal may be transmitted between the first electronic component 48 and the second electronic component 49.

A quantity of third conduction portions 416 and a quantity of first signal channels 61 are the same, and the third conduction portions 416 and the first signaling channels 61 are in a one-to-one correspondence, so that each first signal channel 61 of the connection board 6 can be in conduction with the second electronic component 49 through one third conduction portion 416, to implement transmission of the second electronic component signal in each transmission path. In this case, in addition to the first signal channel 61, the transmission path of the second electronic component signal further includes the third conduction portion 416.

Still refer to FIG. 15. The second electronic component 49 may be located on a side of the connection board 6 facing the first electronic component 48. The first end of the first signal channel 61 and the second end of the first signal channel 61 are formed on a side of the connection board 6 facing the circuit board body 41, to ensure that the first signal channel 61 is in conduction with the first electronic component 48 and the second electronic component 49.

When the second electronic component 49 is located on the side of the connection board 6 facing the first electronic component 48, the second electronic component 49 may be connected to a side of the circuit board body 41 on which the first electronic component 48 is arranged, to ensure that the first electronic component 48 is in conduction with the second electronic component 49, to avoid generation of a stub during transmission of the second electronic component signal in the first signal hole 411. In this way, when the quality of the second electronic component signal is improved, the first electronic component 48 and the second electronic component 49 can be arranged on the same surface of the circuit board body 41.

In addition, when the first electronic component 48 and the second electronic component 49 are on the same surface of the circuit board body 41, the second electronic component 49 can be further arranged on the circuit board 4 by using a component height of the first electronic component 48 on the circuit board body 41, and impact of the arrangement of the second electronic component 49 on a board thickness of the circuit board assembly can also be avoided, to ensure that the electronic device 100 has a small thickness.

Because the first electronic component 48 and the second electronic component 49 are on the same surface of the circuit board body 41, to facilitate conduction between the connection board 6 and the second electronic component 49, the signal hole may further include a second signal hole 412. A structure of the second signal hole 412 is the same as that of the first signal hole 411. For details, refer to the related descriptions of the foregoing first signal hole 411. The second signal hole 412 is provided at a location corresponding to the third conduction portion 416 on the circuit board body 41. In other words, a quantity of second signal holes 412 and a quantity of the third conduction portions 416 are the same, and the second signal holes 412 and the third conduction portions 416 are in a one-to-one correspondence. The second signal hole 412 is located on a side of the third conduction portion 416, and is directly connected to the third conduction portion 416.

A first end of the second signal hole 412 is connected to the second electronic component 49, and a second end of the second signal hole 412 is connected to the third conduction portion 416. Through connections among the second signal hole 412, the second electronic component 49, and the third conduction portion 416, when the second electronic component 49 is in conduction with the connection board 6, the second signal hole 412 can be fully used (100% used), to avoid generation of a stub during transmission of the second electronic component signal in the second signal hole 412, thereby further improving the quality of the second electronic component signal.

Still refer to FIG. 15. A fourth conduction portion 417 is provided between the second electronic component 49 and the circuit board body 41. For example, the fourth conduction portion 417 may be a soldering portion or the like. The second electronic component 49 may be connected to the first end of the second signal hole 412 through the fourth conduction portion 417, to implement the connection between the second electronic component 49 and the first end of the second signal hole 412, so that the second electronic component 49 is in conduction with the connection board 6. In this case, in addition to the third conduction portion 416, the transmission path of the second electronic component signal further includes the second signal hole 412 and the fourth conduction portion 417.

A quantity of fourth conduction portions 417 and a quantity of second signal holes 412 are the same, and the fourth conduction portions 417 and the second signal holes 412 are in a one-to-one correspondence, so that each second signal hole 412 is correspondingly connected to the fourth conduction portion 417. The second signal hole 412 is located on a side of the fourth conduction portion 417, and is directly connected to the fourth conduction portion 417.

The second electronic component 49 has a second projection region on the circuit board body 41. The projection of the connection board 6 on the circuit board body 41 and the second projection region have a second overlapping region S2. The second signal hole 412 is located in the second overlapping region S2, so that the second electronic component 49 can be close to the first electronic component 48 when the second electronic component 49 is in conduction with the connection board 6 through the second signal hole 412, thereby improving the quality of the second electronic component signal.

Refer to FIG. 9 again. When a spacing between the fourth conduction portions 417 is large, the second electronic component 49 may be directly connected to the first end of the second signal hole 412 through the fourth conduction portion 417.

FIG. 16 is a schematic diagram of a structure of a third circuit board assembly according to this application. Refer to FIG. 16. When the spacing between the fourth conduction portions 417 is small so that the second signal hole 412 on the circuit board body 41 cannot be arranged between adjacent fourth conduction portions 417, the circuit board assembly may further include a transit board 7. The second electronic component 49 may be connected to the first end of the second signal hole 412 through the transit board 7, to ensure that the second signal hole 412 is provided on the circuit board body 41 when the second electronic component 49 is in conduction with the circuit board body 41 through the transit board 7.

To avoid generation of a stub during transmission of the second electronic component signal in the transit board 7, the transit board 7 may be an any-order high density interconnector. For example, the transit board 7 may be an any-order four-layer high density interconnector, an any-order six-layer high density interconnector, an any-order eight-layer high density interconnector, an any-order ten-layer high density interconnector, or the like. Because adjacent conductive circuit layers 62 in the any-order high density interconnector are interconnected through the conductive portion 65, any conductive circuit layers 62 may be interconnected through the conductive portion 65. In this way, when the second electronic component signal is transmitted to the transit board 7, a required quantity of conductive circuit layers 62 may be selected in the transit board 7 for cabling according to a cabling requirement of the second electronic component signal, and a stub is not generated.

The second electronic component 49 may be connected to a first end of a second signal channel 71 in the transit board 7 through the fourth conduction portion 417, and a second end of the second signal channel 71 may be in conduction with the first end of the second signal hole 412 through a fifth conduction portion 418. In this case, in addition to the fourth conduction portion 417, the transmission path of the second electronic component signal further includes the second signal channel 71 and the fifth conduction portion 418.

It should be noted that the second signal channel 71 is formed by the conductive portion 65 through which the second electronic component signal passes in the transit board 7.

FIG. 17 is a schematic diagram of a structure of a fourth circuit board assembly. Refer to FIG. 17. When the first electronic component 48 and the second electronic component 49 are on the same surface of the circuit board body 41, the second electronic component 49 may be located in the circuit board body 41. In this case, the second electronic component 49 may still be in direct conduction with the second end of the first signal channel 61 through the third conduction portion 416, so that the second electronic component 49 can be hidden in the circuit board body 41 when the second electronic component 49 is in conduction with the second electronic component 49, to prevent an excessively thick circuit board assembly from affecting a thickness of the body 2 of the electronic device 100. Refer to the direction Z. A direction in which the thickness of the body 2 is located is the same as a direction in which the thickness of the circuit board body 41 is located.

A mounting hole is provided in the circuit board body 41, and the second electronic component 49 may be located in the mounting hole, so that the second electronic component 49 is arranged in the circuit board body 41. In this case, the second signal hole 412 does not need to be provided in the circuit board body 41.

The transit board 7 is the any-order high density interconnector. Therefore, when the second electronic component 49 may be connected to the first end of the second signal hole 412 through the transit board 7, the transit board 7 may be used as the connection board 6, and a stub in the first signal hole 411 can also be eliminated, and the connection board 6 does not need to be additionally arranged.

Still refer to FIG. 17. The circuit board assembly may further include an isolation member 9. The isolation member 9 covers at least one side of the second electronic component 49, so that the second electronic component 49 is shielded by the isolation member 9, to prevent the second electronic component 49 from affecting another signal of the electronic device 100. For example, when the second electronic component 49 is the random access memory 43 (DDR), impact of noise generated during operation of the second electronic component 49 on a wireless network communication (WiFi) signal of the electronic device 100 can be shielded through the isolation member 9.

The isolation member 9 may include an isolation hood or an isolation plate. For example, the isolation hood may be a metal isolation hood, and the isolation plate may be a copper foil, an aluminum foil, a high density interconnector with a small size, or the like. When the isolation plate is the high density interconnector, a cabling space of the circuit board assembly can be further increased. Multiple sides of the second electronic component 49 can be covered by the isolation hood. A side of the second electronic component 49 away from the connection board 6 can be covered by the isolation plate. When the isolation hood or the isolation plate uses the same material and has the same board thickness, compared with the isolation plate, the isolation hood has a better isolation effect for the second electronic component 49.

The isolation hood or the isolation plate of the isolation member 9 is arranged, so that a structure of the isolation member 9 can be diversified when the second electronic component 49 can be shielded, to adapt to design requirements of the circuit board assembly on the isolation member 9 in different scenarios.

For example, when the second electronic component 49 projects from a side of the circuit board body 41 facing the first electronic component 48, an isolation hood may cover an outer side of the second electronic component 49. The isolation hood may be connected to the connection board 6 or the circuit board body 41 in a manner such as soldering, to implement assembly and fixing of the isolation hood in the circuit board assembly.

For example, when the second electronic component 49 does not protrude from the side of the circuit board body 41 facing the first electronic component 48, the isolation plate may be used to cover the side of the second electronic component 49 away from the connection board 6. The isolation plate may be connected to the circuit board body 41 in the manner such as soldering, to implement assembly and fixing of the isolation plate in the circuit board assembly.

When the first electronic component 48 and the second electronic component 49 are arranged on the same surface of the circuit board body 41, to implement conduction between the first electronic component 48 and the second electronic component 49 through the connection board 6 and ensure that a stub is not generated during transmission of the second electronic component signal in the first signal channel 61 in the connection board 6, adjacent conductive circuit layers 62 in the core board unit 64 of the connection board 6 are interconnected through the conductive portion 65. In other words, the connection board 6 may be an any-order high density interconnector. Therefore, a required quantity of conductive circuit layers 62 may be selected in the transit board 7 for cabling according to a cabling requirement of the second electronic component signal in the connection board 6, so that a stub is not generated when the second electronic component signal is transmitted in the connection board 6. The first signal channel 61 is formed by the conductive portion 65 through which the second electronic component signal passes in the connection board 6.

A transmission path of a second electronic component signal is further described below by using an example in which the cabling of the second electronic component 49 in the connection board 6 needs to occupy three conductive circuit layers 62 in an any-order ten-layer connection board 6.

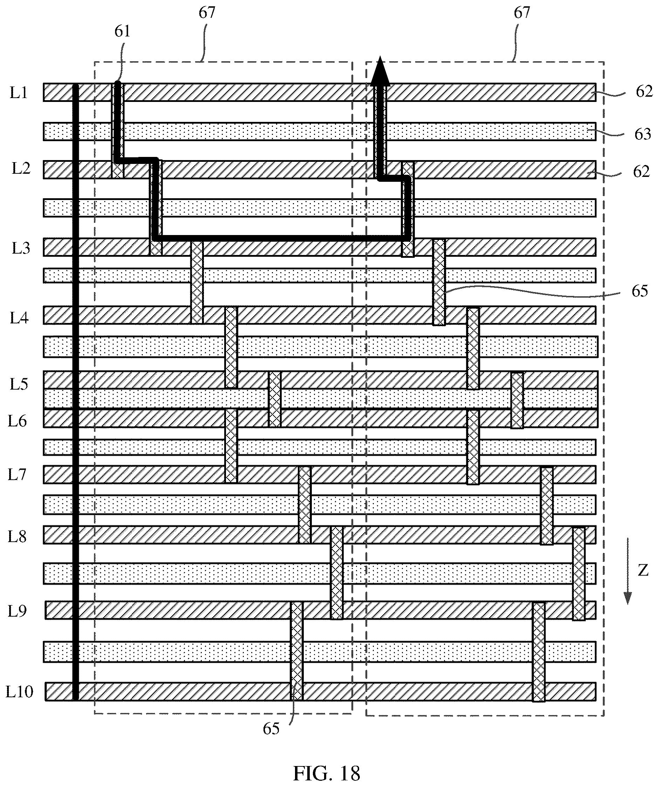

FIG. 18 is a first schematic diagram of cabling of a second electronic component signal in a connection board 6 when a first electronic component 48 and a second electronic component 49 are arranged on the same surface of the connection board 6. FIG. 18 shows two conductive groups 67. Each of the conductive groups 67 includes a plurality of conductive portions 65 connecting conductive circuit layers 62 in the same region of the connection board 6. For the any-order ten-layer connection board 6, each of the conductive groups 67 includes nine conductive portions 65 sequentially arranged along the direction Z.

Refer to FIG. 18. Similarly, along the direction Z, the ten conductive circuit layers 62 in the connection board 6 are sequentially represented as L1, L2, L3, L4, L5, L6, L7, L8, L9, and L10. It is assumed that the second electronic component signal needs to occupy three conductive circuit layers 62 in the connection board 6 for cabling, and the three occupied conductive circuit layers 62 in the connection board 6 are L3, L5, and L7.

Still refer to FIG. 18. During cabling of the second electronic component signal on the conductive circuit layer 62 L3, the second electronic component signal may sequentially pass through the conductive portion 65 between the conductive circuit layer 62 L1 and the conductive circuit layer 62 L2 and the conductive portion 65 between the conductive circuit layer 62 L2 and the conductive circuit layer 62 L3 in the left conductive group 67; then performs cabling on the conductive circuit layer 62 L3; and then sequentially passes through the conductive portion 65 between the conductive circuit layer 62 L2 and the conductive circuit layer 62 L3 and the conductive portion 65 between the conductive circuit layer 62 L2 and the conductive circuit layer 62 L1 in the right conductive group 67, to be transmitted to the second electronic component 49.

The first signal channel 61 is formed by the conductive portion 65 through which the second electronic component signal passes in the connection board 6. In addition to the conductive portion 65, the first signal channel 61 further includes cabling of the second electronic component signal on the conductive circuit layer 62 L3. The second electronic component signal may also be transmitted to the first electronic component 48 along the first signal channel 61.

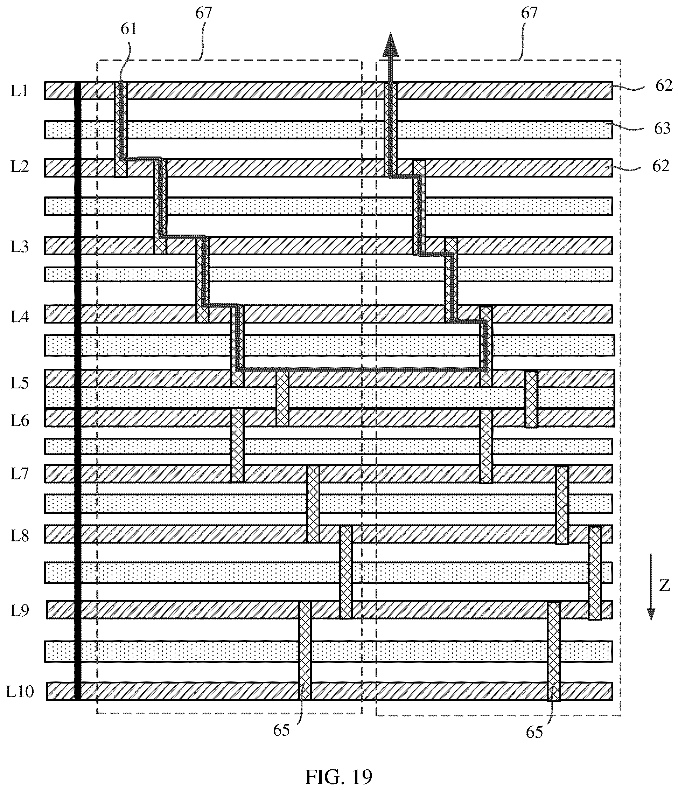

FIG. 19 is a second schematic diagram of cabling of a second electronic component signal in a connection board 6 when a first electronic component 48 and a second electronic component 49 are arranged on the same surface of the connection board 6. Refer to FIG. 19. During cabling of the second electronic component signal on the conductive circuit layer 62 L5, a difference with the cabling of the second electronic component signal on the conductive circuit layer 62 L3 lies in that, after the second electronic component signal passes through the conductive portion 65 between the conductive circuit layer 62 L2 and the conductive circuit layer 62 L3, the second electronic component signal continues to sequentially pass through the conductive portion 65 between the conductive circuit layer 62 L3 and the conductive circuit layer 62 L4 and the conductive portion 65 between the conductive circuit layer 62 L4 and the conductive circuit layer 62 L5 in the left conductive group 67; then performs cabling on the conductive circuit layer 62 L5; and then sequentially passes through four conductive portions 65 in the right conductive group 67 along a transmission direction shown in FIG. 19, to be transmitted to the second electronic component 49. In this case, in addition to the conductive portion 65, the first signal channel 61 further includes cabling of the second electronic component signal on the conductive circuit layer 62 L5.

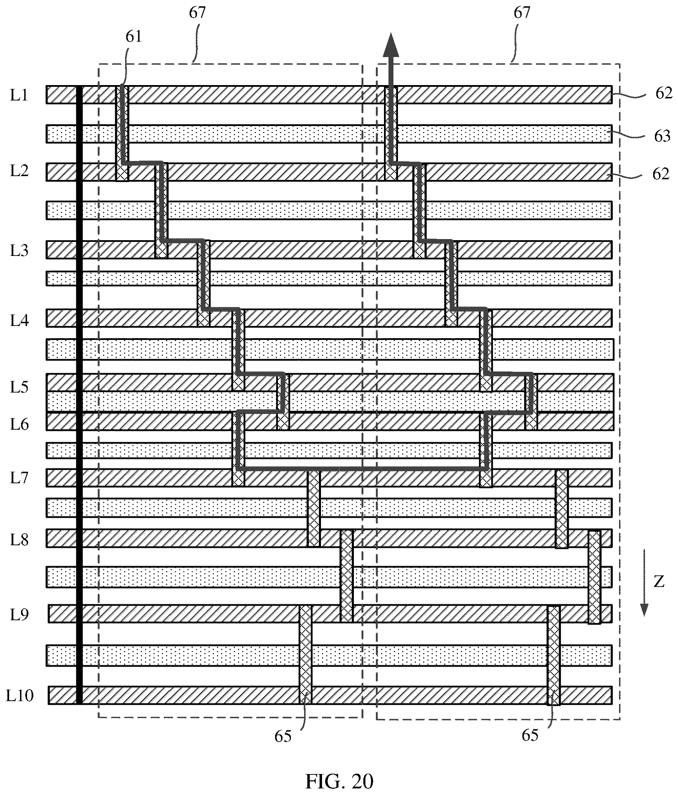

FIG. 20 is a third schematic diagram of cabling of a second electronic component signal in a connection board 6 when a first electronic component 48 and a second electronic component 49 are arranged on the same surface of the connection board 6. Refer to FIG. 20. During cabling of the second electronic component signal on the conductive circuit layer 62 L7, a difference with the cabling of the second electronic component signal on the conductive circuit layer 62 L5 lies in that, after the second electronic component signal passes through the conductive portion 65 between the conductive circuit layer 62 L4 and the conductive circuit layer 62 L5, the second electronic component signal continues to sequentially pass through the conductive portion 65 between the conductive circuit layer 62 L5 and the conductive circuit layer 62 L6 and the conductive portion 65 between the conductive circuit layer 62 L6 and the conductive circuit layer 62 L7 in the left conductive group 67; then performs cabling on the conductive circuit layer 62 L7; and then sequentially passes through six conductive portions 65 in the right conductive group 67 along a transmission direction shown in FIG. 20, to be transmitted to the second electronic component 49. In this case, in addition to the conductive portion 65, the first signal channel 61 further includes cabling of the second electronic component signal on the conductive circuit layer 62 L7.

In conclusion, it can be seen that, when the second electronic component signal passes through the first signal channel 61 of the connection board 6, a stub is not generated.

It should be noted that when the cabling of the second electronic component signal in the transit board 7 is simple, the connection board 6 may also be the low-order high density interconnector, and a stub is not generated. For example, when the cabling of the second electronic component signal in the transit board 7 is on only a conductive circuit layer 62 located on a surface layer, the connection board 6 may be a one-order high density interconnector.

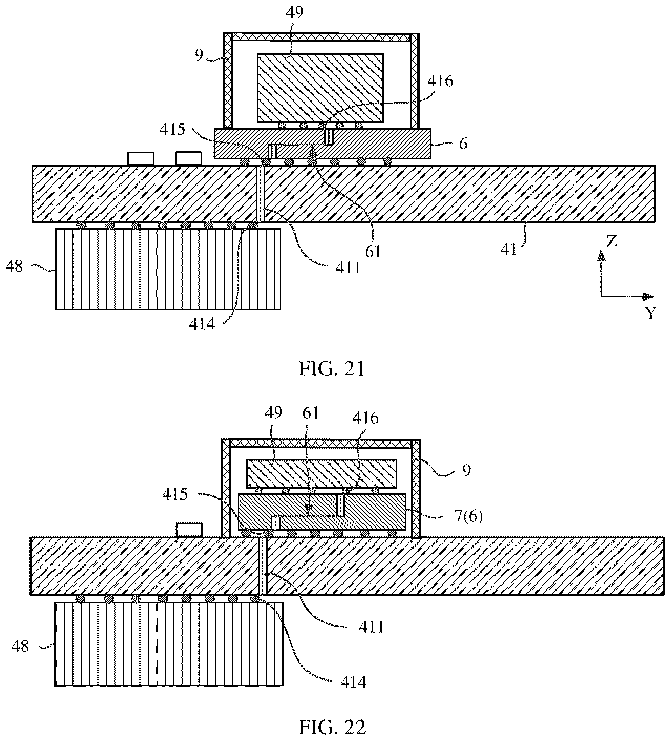

FIG. 21 is a schematic diagram of a structure of a fifth circuit board assembly according to this application. Refer to FIG. 21. In some embodiments, the second electronic component 49 may alternatively be located on a side of the connection board 6 away from the first electronic component 48, so that the second electronic component 49 and the first electronic component 48 are arranged on different surfaces of the circuit board body 41. In this case, the first end of the first signal channel 61 is formed on the side of the connection board 6 facing the circuit board body 41, and the second end of the first signal channel 61 is formed on a side of the connection board 6 facing the second electronic component 49, so that the second electronic component 49 s in conduction with the first electronic component 48 through the first signal channel 61, so that the second electronic component signal can be transmitted between the first electronic component 48 and the second electronic component 49.

Still refer to FIG. 21. The second electronic component 49 may be connected to the second end of the signal path of the connection board 6 through the third conduction portion 416, so that the second electronic component 49 is in conduction with the first electronic component 48.

FIG. 22 is a schematic diagram of a structure of a sixth circuit board assembly according to this application. Refer to FIG. 22. If the height of the circuit board assembly facing the surface C of the electronic device 100 is allowed, when the second electronic component 49 is connected to the circuit board body 41 through the transit board 7 and the transit board 7 is the any-order high density interconnector, the transit board 7 may also be used as the connection board 6, a stub in the first signal hole 411 can also be eliminated, and the connection board 6 does not need to be additionally arranged, so that the structure of the circuit board assembly can be simplified.

When the second electronic component 49 may alternatively be located on the side of the connection board 6 away from the first electronic component 48, the isolation member 9 may be the isolation hood. When the isolation hood covers the outer side of the second electronic component 49, the isolation hood may be connected to the connection board 6 or the circuit board body 41 in the manner such as soldering, to implement assembly and fixing of the isolation member 9 in the circuit board assembly.

When the second electronic component 49 may alternatively be located on the side of the connection board 6 away from the first electronic component 48, the connection board 6 may be the any-order high density interconnector. In this way, a required quantity of conductive circuit layers 62 may be selected in the transit board 7 for cabling according to a cabling requirement of the second electronic component signal in the connection board 6, so that a stub is not generated when the second electronic component signal is transmitted in the connection board 6.

A transmission path of the second electronic component signal is further described below by using an example in which the connection board 6 is the any-order ten-layer high density interconnector.

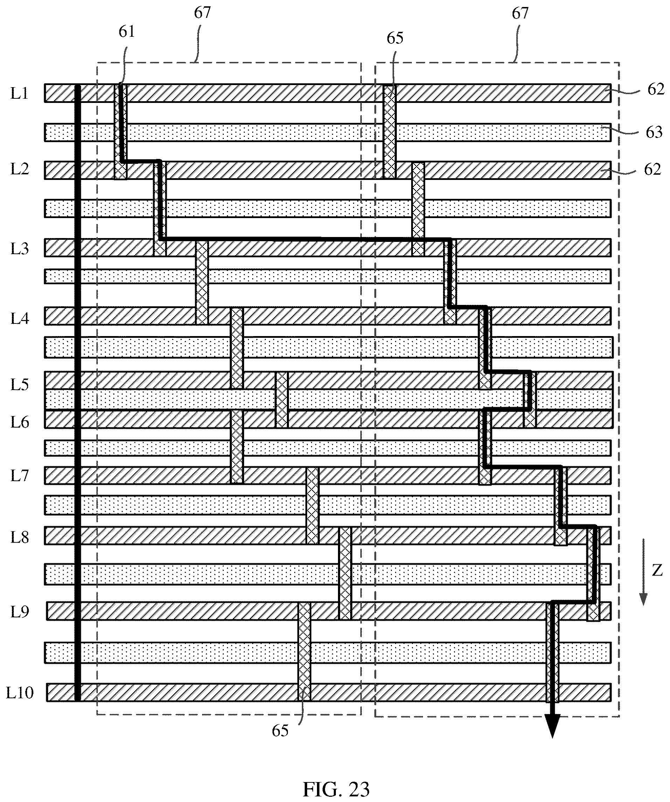

FIG. 23 is a first schematic diagram of cabling of a second electronic component signal in a connection board 6 when a first electronic component 48 and a second electronic component 49 are arranged on different surfaces of the connection board 6. Similarly, it is assumed that the second electronic component signal needs to occupy three conductive circuit layers 62 in the connection board 6 for cabling, and the three occupied conductive circuit layers 62 in the connection board 6 are L3, L5, and L7.

Still refer to FIG. 23. During cabling of the second electronic component signal on the conductive circuit layer 62 L3, the second electronic component signal may sequentially pass through the conductive portion 65 between a conductive circuit layer 62 L1 and a conductive circuit layer 62 L2 and the conductive portion 65 between the conductive circuit layer 62 L2 and the conductive circuit layer 62 L3 in the left conductive group 67; then performs cabling on the conductive circuit layer 62 L3; and then sequentially passes through seven conductive portions 65 in the right conductive group 67 to reach a conductive circuit layer 62 L10, to be transmitted to the second electronic component 49.

The first signal channel 61 is formed by the conductive portion 65 through which the second electronic component signal passes in the connection board 6. In addition to the conductive portion 65, the first signal channel 61 further includes cabling of the second electronic component signal on the conductive circuit layer 62 L3. The second electronic component signal may also be transmitted to the first electronic component 48 along the first signal channel 61.

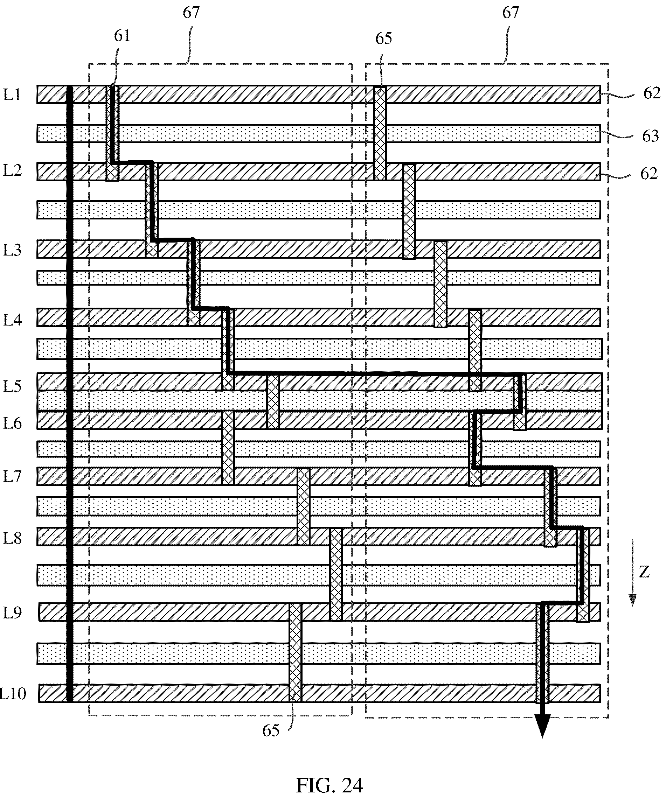

FIG. 24 is a second schematic diagram of cabling of a second electronic component signal in a connection board 6 when a first electronic component 48 and a second electronic component 49 are arranged on different surfaces of the connection board 6. Refer to FIG. 24. During cabling of the second electronic component signal on the conductive circuit layer 62 L5, a difference with the cabling of the second electronic component signal on the conductive circuit layer 62 L3 lies in that, after the second electronic component signal passes through the conductive portion 65 between the conductive circuit layer 62 L2 and the conductive circuit layer 62 L3, the second electronic component signal continues to pass through the conductive portion 65 between the conductive circuit layer 62 L3 and a conductive circuit layer 62 L4 and the conductive portion 65 between the conductive circuit layer 62 L4 and the conductive circuit layer 62 L5 in the left conductive group 67; then performs cabling on the conductive circuit layer 62 L5; and then sequentially passes through five conductive portions 65 in the right conductive group 67 to reach the conductive circuit layer 62 L10, to be transmitted to the second electronic component 49. In addition to the conductive portion 65, the first signal channel 61 further includes cabling of the second electronic component signal on the conductive circuit layer 62 L5.

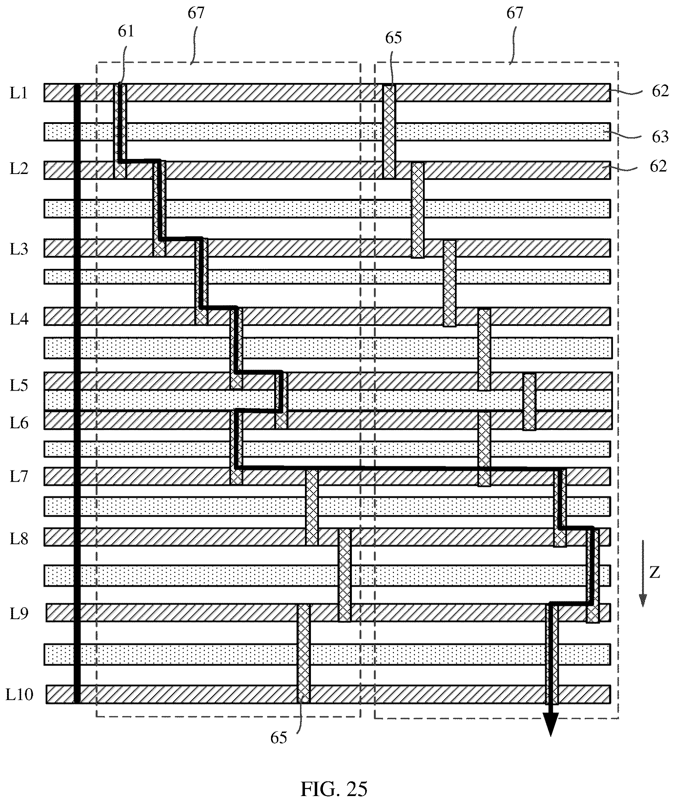

FIG. 25 is a third schematic diagram of cabling of a second electronic component signal in a connection board 6 when a first electronic component 48 and a second electronic component 49 are arranged on different surfaces of the connection board 6. Refer to FIG. 25. During cabling of the second electronic component signal on the conductive circuit layer 62 L7, a difference with the cabling of the second electronic component signal on the conductive circuit layer 62 L5 lies in that, after the second electronic component signal passes through the conductive portion 65 between the conductive circuit layer 62 L4 and the conductive circuit layer 62 L5, the second electronic component signal continues to pass through the conductive portion 65 between the conductive circuit layer 62 L5 and a conductive circuit layer 62 L6 and the conductive portion 65 between the conductive circuit layer 62 L6 and the conductive circuit layer 62 L7 in the left conductive group 67; then performs cabling on the conductive circuit layer 62 L7; and then sequentially passes through three conductive portions 65 in the right conductive group 67 to reach the conductive circuit layer 62 L10, to be transmitted to the second electronic component 49. In addition to the conductive portion 65, the first signal channel 61 further includes cabling of the second electronic component signal on the conductive circuit layer 62 L7.

In the descriptions of this application, it should be understood that the terms "center", "longitudinal", "transverse", "length", "width", "thickness", "up", "down", "front", "back", "left", "right", "vertical", "horizontal", "top", "bottom", "inside", "outside", and the like indicate orientation or locational relationships based on the orientation or locational relationships shown in the accompanying drawings, are used merely for the convenience of describing this application and simplifying the description instead of indicating or implying that the apparatus or component referred to should have a specific orientation or be constructed and operated in a specific orientation. Therefore, the terms should not be understood as a limitation of this application.

In the descriptions of this application, it should be understood that the terms "include", "have", and any other variants thereof used herein are intended to cover a nonexclusive inclusion. For example, a process, method, shown structure, product, or device that includes a list of steps or units is not necessarily limited to those steps or units that are clearly listed, but may include other steps or units that are not clearly listed or are inherent to the process, method, system, product, or device.

The term "and/or" used in this application describes only an association relationship between associated objects and represents that three relationships may exist. For example, A and/or B may represent the following three cases: Only A exists, both A and B exist, and only B exists. In addition, the character "/" herein usually represents an "or" relationship between associated objects.

Unless otherwise specified or limited, the terms "install", "communicate", and "connect" shall be understood in a broad sense, for example, may indicate a fixed connection, an indirect connection by using an intermediate medium, or internal communication between two elements or an interaction relationship between two elements. For a person of ordinary skill in the art, specific meanings of the foregoing terms in embodiments of this application may be understood based on a specific situation.

The terms "first", "second", "third", "fourth", and the like (if any) in the specification, claims, and accompanying drawings of embodiments of this application are used for distinguishing between similar objects and not necessarily used for describing any particular order or sequence.

## Claims

1. A circuit board assembly, comprising:
a circuit board, having a circuit board body and a first electronic component, wherein the first electronic component is located on the circuit board body; and a signal hole is provided on the circuit board body, and the signal hole comprises a first signal hole;
a connection board, located on a side of the circuit board body opposite to the first electronic component, and in conduction with the first electronic component through the first signal hole; and
a second electronic component, in conduction with the connection board.

2. The circuit board assembly according to claim 1, wherein the connection board is a high density interconnector, a first signal channel is provided in the connection board, a first end of the first signal channel is in conduction with the first electronic component through the first signal hole, and a second end of the first signal channel is in conduction with the second electronic component; and
when a signal between the second electronic component and the first electronic component is transmitted in the first signal channel, a stub is not generated in the first signal channel of the connection board.

3. The circuit board assembly according to claim 2, wherein a first conduction portion is provided between the first electronic component and the circuit board body, and the first electronic component is connected to a first end of the first signal hole through the first conduction portion; and a second conduction portion is provided between the connection board and the circuit board body, and a second end of the first signal hole is connected to the first end of the first signal channel through the second conduction portion.

4. The circuit board assembly according to claim 3, wherein the first signal hole is located on a side of the first conduction portion.

5. The circuit board assembly according to claim 3, wherein a plurality of first conduction portions are provided, and each first conduction portion is provided with the first signal hole and the second conduction portion correspondingly; and
each second conduction portion of the connection board is provided with the first signal channel correspondingly.

6. The circuit board assembly according to claim 2, wherein a third conduction portion is provided between the second electronic component and the connection board, and the third conduction portion is connected between the second end of the first signal channel and the second electronic component.

7. The circuit board assembly according to claim 6, wherein the second electronic component is located on a side of the connection board facing the first electronic component; and the first end of the first signal channel and the second end of the first signal channel are formed on a side of the connection board facing the circuit board body.

8. The circuit board assembly according to claim 7, wherein the second electronic component is connected to a side of the circuit board body on which the first electronic component is arranged.

9. The circuit board assembly according to claim 8, wherein the signal hole further comprises a second signal hole, and the second signal hole is provided at a location corresponding to the third conduction portion on the circuit board body; and
a first end of the second signal hole is connected to the second electronic component, and a second end of the second signal hole is connected to the third conduction portion.

10. The circuit board assembly according to claim 9, wherein a fourth conduction portion is provided between the second electronic component and the circuit board body, and the second electronic component is connected to the first end of the second signal hole through the fourth conduction portion.

11. The circuit board assembly according to claim 9, further comprising a transit board, wherein the second electronic component is connected to the first end of the second signal hole through the transit board.

12. The circuit board assembly according to claim 9, wherein the second electronic component has a second projection region on the circuit board body;
a projection of the connection board on the circuit board body and the second projection region have a second overlapping region; and the second signal hole is located in the second overlapping region.

13. The circuit board assembly according to claim 7, wherein the second electronic component is located in the circuit board body.

14. The circuit board assembly according to claim 6, wherein the second electronic component is located on a side of the connection board away from the first electronic component; and
the first end of the first signal channel is formed on the side of the connection board facing the circuit board body, and the second end of the first signal channel is formed on a side of the connection board facing the second electronic component.

15. The circuit board assembly according to claim 6, wherein a quantity of third conduction portions and a quantity of first signal channels are the same, and the third conduction portions and the first signaling channels are in a one-to-one correspondence.

16. The circuit board assembly according to any one of claims 2 to 15, wherein the connection board comprises a conductive portion and a plurality of stacked conductive circuit layers, and adjacent conductive circuit layers are insulated from each other;
at least two conductive circuit layers located in a middle layer of the connection board form a core board unit of the connection board, and adjacent conductive circuit layers located on a side of the core board unit are interconnected through the conductive portion; and
the first signal channel is at least formed at the conductive portion on a side of the core board unit facing the circuit board body.

17. The circuit board assembly according to claim 16, wherein adjacent conductive circuit layers in the core board unit are interconnected through the conductive portion.

18. The circuit board assembly according to any one of claims 1 to 15, wherein the signal hole comprises a signal via or a signal buried via on the circuit board body.

19. The circuit board assembly according to any one of claims 1 to 15, wherein the first electronic component has a first projection region on the circuit board body;
the projection of the connection board on the circuit board body and the first projection region have a first overlapping region; and the first signal hole is located in the first overlapping region.

20. The circuit board assembly according to any one of claims 1 to 15, wherein the circuit board body has a first surface and a second surface in a board thickness direction, and the second surface faces a keyboard of the electronic device; and
the first electronic component is arranged on the first surface, and the connection board is arranged on the second surface.

21. The circuit board assembly according to any one of claims 1 to 15, further comprising an isolation member, wherein the isolation member covers at least one side of the second electronic component.

22. The circuit board assembly according to claim 21, wherein the isolation member comprises an isolation hood or an isolation plate.

23. The circuit board assembly according to any one of claims 1 to 15, wherein the first electronic component comprises a processor, and the second electronic component comprises a memory.

24. An electronic device, comprising a housing and the circuit board assembly according to any one of claims 1 to 23, wherein the circuit board assembly is located in the housing.
